# EUROPÄISCHE PATENTSCHRIFT

(11) **EP 3 678 866 B1**
(45) Veröffentlichungstag und Bekanntmachung des Hinweises auf die Patenterteilung: **07.06.2023**
(21) Anmeldenummer: 18759030.2
(22) Anmeldetag: 27.08.2018
(51) Int. Cl.: F16K 27/00, F16K 41/10, F16K 27/02, B41J 2/14, F16K 31/00

(54) **ANORDNUNG ZUR POSITIONIERUNG EINER AKTUATORVORRICHTUNG**
ARRANGEMENT FOR POSITIONING AN ACTUATOR DEVICE
DISPOSITIF DE POSITIONNEMENT D'UN DISPOSITIF D'ACTIONNEMENT

(30) Priorität: 04.09.2017 IT 201700098731
(43) Veröffentlichungstag der Anmeldung: 15.07.2020
(73) Patentinhaber: Durst Group AG, 39042 Brixen (IT)
(72) Erfinder: GASSER, Herbert, 39042 Brixen (IT); OBERTEGGER, Franz, 39042 Brixen (IT)
(74) Vertreter: Kempkens, Anke
(86) Internationale Anmeldenummer: PCT/EP2018/025224
(87) Internationale Veröffentlichungsnummer: WO 2019/042586

(56) Entgegenhaltungen:
- EP-A1- 1 440 266
- EP-A1- 2 732 883
- WO-A1-2013/013983
- US-A- 4 723 131
- US-A1- 2003 227 232
- US-A1- 2005 211 166
- US-A1- 2016 176 187

## Beschreibung

Die vorliegende Erfindung betrifft eine Anordnung zur Positionierung einer Aktuatorvorrichtung und ferner einen Druckkopf mit der Anordnung zur Positionierung der Aktuatorvorrichtung gegenüber einem Tragköper der Anordnung gemäß den Oberbegriffen der Ansprüche 1 und 20.

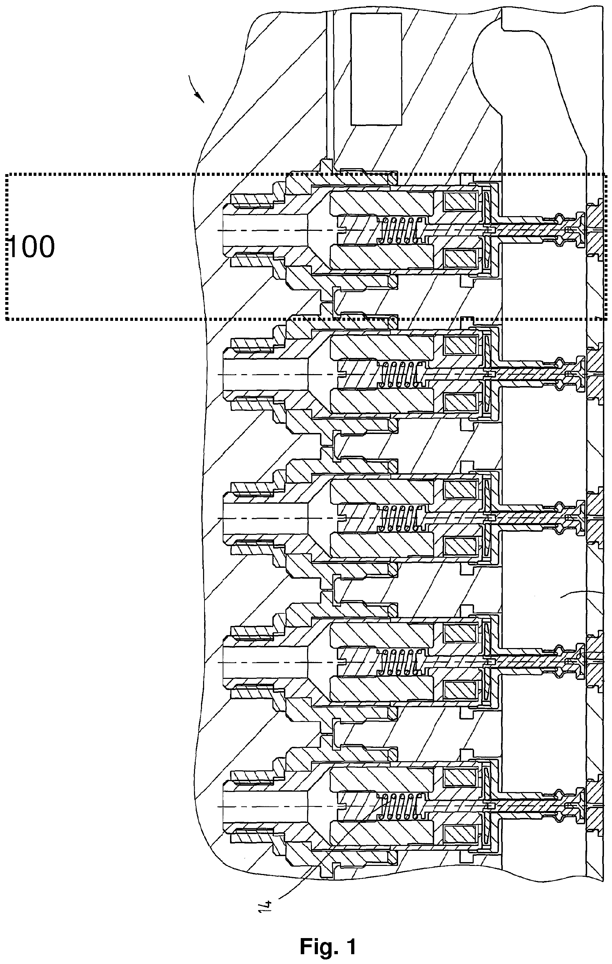

Weiter betrifft die Erfindung ein Verfahren nach Anspruch 25 zur korrigierenden Justierung eines ersten Istabstandes X1 der Anordnung, der als aktueller Abstand zwischen der Stösselstirnseite und einer Unterseite des Tragkörpers definiert ist, in Bezug auf einen Abstand A, der als Abstand zwischen einer Einsetzöffnung einer Trägerseitenwand und der Einströmöffnung einer Düse des Druckkopfes definiert ist. Aus dem als nächstliegenden Stand der Technik angesehenen Dokument WO 2013/013983 A1 der gleichnamigen Anmelderin ist eine Anordnung zur Positionierung einer Stösselstirnseite gegenüber einem Tragkörper mit den Merkmalen des Oberbegriffs des Anspruchs 1 bekannt. Eine solche Anordnung ist im im strichliertem Rechteck in Figur 1 in der gegenständlichen Anmeldung dargestellt. Figur 1 offenbart eine Anordnung für einen Druckkopf mit einem Tragkörper zur Fixierung der Anordnung am Druckkopf. Dabei wird ein durch ein Durchgangsloch des Tragkörpers hindurch gesteckter und darin gelagerter Grundkörper einer Aktuatorvorrichtung beschrieben, der erste Mittel umfasst zur Bewegung eines Stössels, über die der Stössel am Grundkörper angebracht ist und bei elektrischer Ansteuerung derselben relativ dazu bewegbar ist. Der Grundkörper umfasst einen Basiskörper, der eine Bodenwand mit Durchgangsöffnung einschließt, aus der sich eine einen Raum zur Aufnahme eines Stellelements des ersten Mittels zur Bewegung der Stösselstirnseite umschließende Umfangswand erstreckt und einen Deckel zum Schließen des Basiskörpers.

Die ersten Mittel umfassen einen Zugmagneten mit einem Elektromagneten und einem Anker, den Stössel mit der Stösselstirnseite und eine Stösselstange, wobei die Stösselstange am Stössel und am Anker angebracht ist und der Anker im Basiskörper so gehaltert ist, dass die Stösselstange aus dem Basiskörper durch die Duchgangsöffnung über einen Hohlschaft hinausragt und sich die Stösselstirnseite außerhalb des Basiskörpers befindet.

Der Grundkörper selbst steht mit einem auf dem Tragkörper gelagertem Element zur Positionierung des Stössels relativ zu dem Tragkörper im Eingriff.

Darüber hinaus offenbart dieses Dokument einen Druckkopf für einen Tintenstrahldrucker umfassend die oben beschriebene Anordnung, wobei der Druckkopf zumindest einen Tintenversorgungskanal und zumindest eine Düse mit Düsenkanal und Einströmöffnung aufweist, wobei durch die Einströmöffnung Tinte aus dem Tintenversorgungskanal in den Düsenkanal gepresst und aus diesem ausgestoßen werden kann. Dabei ist die Düse ortsfest an einer Seitenwand des Tintenversorgungskanals angeordnet und der zumindest einen Düse ist ein Stössel mit im Tintenversorgungskanal liegender Stösselstirnseite zugeordnet, die der Einströmöffnung beabstandet gegenüber liegt.

Der Druckkopf gemäss Stand der Technik umfasst erste Mittel zum Bewegen der Stösselstirnseite zwischen einem von der Einströmöffnung der Düse minimal beabstandeten Umkehrpunkt U1 und einem von der Einströmöffnung der Düse maximal beabstandeten Umkehrpunkt U2 wobei die ersten Mittel die Bewegung der Stösselstirnseite auf eine Bewegung zwischen den Umkehrpunkten (U1,U2) begrenzen. Er umfasst ausserdem zweite Mittel zum Beaufschlagen der Tinte im Tintenversorgungskanal mit einem Unterdruck relativ zum Umgebungsluftdruck, wobei der Druckkopf eine der Seitenwand gegenüberliegende Trägerseitenwand zur Ablage des Tragkörpers der Anordnung umfasst. Die Trägerseitenwand umfasst eine Durchgangsöffnung zur Aufnahme des Grundkörpers der Aktuatorvorrichtung der Anordnung.

Unterschiedliche Faktoren beeinflussen den Druckvorgang eines Substrates, insbesondere den Tropfenausstoss aus einer Düse eines Druckkopfes. Hierzu gehören unter anderem:
- der Abstand zwischen der Stösselstirnseite und der Einströmöffnung der Düse am minimal beabstandeten Umkehrpunkt U1,
- der Abstand zwischen der Stösselstirnseite und der Einströmöffnung der Düse am maximal beabstandeten Umkehrpunkt U2 und damit der entsprechende Hubweg der Stösselstirnseite zwischen den beiden Umkehrpunkten (U1, U2),
- die Frequenz mit der der Richtungswechsel der Stösselstirnseite zwischen den beiden Umkehrpunkten (U1, U2) erfolgt,
- die geometrischen Abmessungen der Düsenöffnung, des Düsenkanals sowie der Stösselsti rn seite:
und was die zu bedruckende Tinte angeht:
- die Temperatur, die Viskosität, die Dichte und gegebenenfalls die Partikelgrößenverteilung von in der Tinte dispergierten Partikeln.

Dabei ist zu beachten, dass sich diese Faktoren auch gegenseitig beeinflussen.

An dieser Stelle sollen vorab einige in diesem Dokument verwendete Begriffe definiert werden:
In dieser Beschreibung ist der erste Istabstand X1 als der aktuelle Abstand zwischen der Stösselstirnseite und der Unterseite des Tragkörpers der Anordnung definiert.

Weiter ist im Dokument der zweite Istabstand X2 als der Abstand zwischen der Stösselstirnseite und der Einströmöffnung der Düse am minimal beabstandeten Umkehrpunkt U1 definiert, wenn die Anordnung am Druckkopf angeordnet ist und damit über den Tragkörper mit dem Druckkopf fixiert ist.

Der Abstand A ist in diesem Dokument als Abstand zwischen einer Einsetzöffnung einer Trägerseitenwand des Tintenversorgungskanals und der Einströmöffnung der Düse definiert, wobei der Abstand A auch der Summe aus erstem Istabstand X1 und zweitem Istabstand X2 entspricht.

Der Erfinder hat beobachtet, dass das Bedrucken eines Substrates mit mehreren im Prinzip baugleichen Druckköpfen aus der WO 2013/013983 A1 umfassend jeweils die oben beschriebene Anordnung mit nicht unwesentlichen Unterschieden zwischen den Tintentropfengrössen der jeweiligen Druckköpfe erfolgt, wenn sich die jeweiligen zweiten Istabstände X2 am jeweiligen minimal beabstandeten Umkehrpunkt U1 um auch nur wenige Mikrometer voneinander unterscheiden.

Beispielsweise wurde beobachtet, dass eine Abweichung des zweiten Istabstandes X2 von einem zweiten vorgegebenen zweiten Sollabstand S2, der als optimaler Abstand am minimal beabstandeten Umkehrpunkt U1 definiert werden kann, von etwa 10% eine etwa 10%-ige Änderung des Tropfenvolumens der aus einer Düse ausgestossenen Tintentropfen bewirkt.

Es lässt sich daher allgemein festhalten, dass unterschiedliche zweite Istabstände X2 zu unterschiedlichen Tropfenvolumina führen. Dementsprechend ist der zweite Istabstand X2 ein ganz besonders wichtiger Faktor für den ordnungsgemässen Betrieb des eingangs erwähnten Druckkopfes, der in der vorliegenden Erfindung als der Abstand am minimal beabstandeten Umkehrpunkt U1 definiert ist.

Ein Nachteil der Anordnung und des Druckkopfes aus der WO 2013/013983 A1 ist nun, dass der erste Istabstand X1 aber nicht einstellbar ist, sodass wenn die Anordnung am Druckkopf angeordnet ist, die genauso keine Einstellmöglichkeit besitzt, auch der zweite Istabstand X2 nicht einstellbar ist, um die Stösselstirnseite auf den vorgegebenen zweiten Sollabstand S2 einstellen zu können.

Die oben angegebene Abstandsabweichung, die sich in der Praxis durch naturgemäß immer vorhandene Fertigungstoleranzen sämtlicher Bestandteile der Anordnung nicht vermeiden lässt, führt dementsprechend dazu, dass im Prinzip baugleich gefertigte Anordnungen unterschiedliche erste Istabstände X1 aufweisen.

Das Problem der Fertigungstoleranzen tritt aber auch im Zusammenhang mit der Bereitstellung des oben genannten zumindest einen Tintenversorgungskanals des Druckkopfes mit der zumindest einer Düse auf.

In jedem Falle verschärft sich das Problem der Fertigungstoleranzen insbesondere dann, wenn mehrere Anordnungen mit einem Tintenversorgungskanal des Druckkopfes kombiniert und über seine Einsetzöffnungen den entsprechenden Düsen des Druckkopfes zugeordnet werden, woraus sich unterschiedliche Abstände A ergeben.

Der Abstand A ist wie einleitend angegeben in diesem Dokument als Abstand zwischen einer Einsetzöffnung einer Trägerseitenwand des Tintenversorgungskanals und der Einströmöffnung der Düse definiert, wobei die Trägerseitenwand als die der Einströmöffnung der Düse gegenüberliegende Seitenwand des Tintenversorgungskanals des Druckkopfes definiert ist. Anstatt der Trägerseitenwand kann aber natürlich auch eine andere Stelle des Tintenversorgungskanals oder des Druckkopfes als Referenz benutzt werden.

Es ist die Regel, dass ein Tintenversorgungskanal eines Druckkopfes an den jeweiligen Einsetzpositionen unterschiedliche Abstände A aufweist, die sich typischerweise im einstelligen bis zweistelligen Mikrometerbereich, d.h. zwischen 1 und 99 Mikrometer, voneinander unterscheiden. Diese Abweichungen bzw. Unterschiede könnten aber auch größer ausfallen.

Führt man sich vor Augen, dass in der Praxis tausende Düsen in einem Tintenstrahldrucker zum Einsatz kommen, denen eine gleich hohe Anzahl an Anordnungen zugeordnet sind, so wird einem sofort klar, dass dies zu einer signifikanten Qualitätsverminderung des Druckbildes führen wird.

Es ist somit zunächst die Aufgabe der vorliegenden Erfindung, eine Anordnung bereitzustellen, die die oben geschilderten Probleme zumindest teilweise, vorzugweise insgesamt löst.

Ein individuell zu bestimmenden ersten Sollabstand S1 ist im Rahmen dieser Beschreibung als der in Bezug auf einen vorgegebenen zweiten Sollabstand S2 korrigierten ersten Istabstand X1 definiert.

Bei der vorliegenden Erfindung entspricht der vorgegebene zweite Istabstand S2 dem Abstand zwischen der Stösselstirnseite und der Einströmöffnung der Düse am minimal beabstandeten Umkehrpunkt U1.

Diese Aufgabe wird durch die Vorrichtung nach Anspruch 1 gelöst. Bevorzugte Ausführungen der erfindungsgemäßen Anordnung sind in den Unteransprüchen beschrieben.

Gemäß Anspruch 1 wird eine Anordnung für einen Druckkopf angegeben mit einem Tragkörper zur Fixierung der Anordnung am Druckkopf, einer Aktuatorvorrichtung mit einem Grundkörper, der am Tragkörper angebracht ist, wobei die Aktuatorvorrichtung erste Mittel umfasst zur Bewegung eines Stössels, über die der Stössel am Grundkörper angebracht ist und bei Ansteuerung derselben relativ dazu bewegbar ist, wobei der Grundkörper mit einem Element zur Positionierung der Aktuatorvorrichtung relativ zum Tragkörper wirkverbunden ist.

Erfindungsgemäß umfasst die Anordnung zusätzlich:
- ein Schraubgelenk, das so ausgebildet ist, dass über dieses der Grundkörper am Tragkörper beweglich anbringbar ist, wobei das Schraubgelenk ein Gewinde und ein Gegengewinde umfasst, das in das Gewinde einschraubbar ist,
- zumindest ein elastisches Element,
- wobei das Schraubgelenk und das zumindest eine elastische Element für die Positionierung der Aktuatorvorrichtung zusammenwirkend so ausgebildet sind, dass das Gewinde und das Gegengewinde mit einer Vorspannung gegeneinander verklemmt werden und dass bei Betätigung des Schraubgelenks eine Bewegung des Grundkörpers relativ zum Tragkörper entlang einer Translationsrichtung bewirkt wird.

Vorteilhaft lässt sich bei dieser Anordnung der erste Istabstand X1 ändern, um ihn in Bezug auf einen vorgegebenen zweiten Sollabstand S2 einstellen zu können. Ferner wird die Aufgabe durch einen Druckkopf nach Anspruch 38 gelöst. Bevorzugte Ausführungen des erfindungsgemässen Druckkopfes sind in den Unteransprüchen beschrieben.

Gemäß Anspruch 21 wird ein Druckkopf für einen Tintenstrahldrucker angegeben, wobei der Druckkopf zumindest einen Tintenversorgungskanal und zumindest eine Düse mit Düsenkanal und Einströmöffnung aufweist. Durch die Einströmöffnung kann Tinte aus dem Tintenversorgungskanal in den Düsenkanal gepresst und aus diesem ausgestossen werden. Die Düse ist ortsfest an einer Seitenwand des Tintenversorgungskanals angeordnet und der zumindest einen Düse ist ein Stössel mit im Tintenversorgungskanal liegender Stösselstirnseite, die der Einströmöffnung beabstandet gegenüber liegt, zugeordnet. Der Druckkopf umfasst erste Mittel zum Bewegen der Stösselstirnseite in dem Tintenversorgungskanal zwischen einem von der Einströmöffnung der Düse minimal beabstandeten Umkehrpunkt U1 und einem von der Einströmöffnung der Düse maximal beabstandeten Umkehrpunkt U2, wobei die ersten Mittel die Bewegung einer Stösselstirnseite auf eine Bewegung zwischen den Umkehrpunkten (U1,U2) begrenzen. Dabei umfasst der Druckkopf eine der Seitenwand gegenüberliegende Trägerseitenwand zur Ablage eins Tragkörpers der erfindungsgemässen Anordnung. Die Trägerseitenwand umfasst eine Durchgangsöffnung zur Aufnahme eines Grundkörpers der genannten Anordnung. Erfindungsgemäß umfasst der Druckkopf eine erfindungsgemässe Anordnung gemäß zumindest einem der Ansprüche 1 bis 20, die am Tintenversorgungskanal angeordnet ist und mit diesem über einen Tragkörper verbunden ist, wobei die ersten Mittel zur Bewegung der Stösselstirnseite Teil der erfindungsgemässen Anordnung sind.

Vorteilhaft ist, dass bei Betätigung des Schraubgelenks eine Bewegung des Grundkörpers relativ zum Tragkörper entlang der vorgegebenen Translationsrichtung und damit eine Änderung eines ersten Istabstandes X1, bewirkt wird, um den ersten Istbestand X1 in Bezug auf einen vorgegebenen zweiten Sollabstand S2 einstellen zu können.

Erfindungsgemäss wird die Aufgabe auch durch ein Verfahren zur korrigierenden Justierung eines aktuellen ersten Istabstandes X1 nach Anspruch 25 gelöst.

Dies erfolgt durch ein Verfahren zur korrigierenden Justierung eines aktuellen ersten Istabstandes X1 einer Anordnung nach zumindest einem der Ansprüche 1 bis 20, der als Abstand zwischen einer Stösselstirnseite und einer Unterseite des Tragkörpers definiert ist, in Bezug auf einen Abstand A eines Tintenversorgungskanals eines Druckkopfes gemäß einem der Ansprüche 21 bis 24, der als Abstand zwischen einer Einsetzöffnung einer Trägerseitenwand des Tintenversorgungskanals und der Einströmöffnung einer Düse des Tintenversorgungskanals definiert ist.

Das Verfahren wird so ausgeführt, dass der aktuelle erste Istabstand X1 auf einen individuell zu bestimmenden ersten Sollabstand S1 hin justiert wird. Dies geschieht, indem das Element der Anordnung entsprechend gedreht wird, sodass falls die Anordnung am Tintenversorgungskanal des Druckkopfs oder an einer Justiervorrichtung angeordnet wird oder ist, auch der zweite Istabstand X2 einem vorgegebenen zweiten Sollabstand S2 entspricht.

Die Erfindung wird nachfolgend anhand bevorzugter Ausführungsbeispiele unter Bezugnahme auf die beiliegenden Zeichnungen näher erläutert.
**Fig. 1** zeigt eine Anordnung gemäß dem Stand der Technik.
**Figuren 2A****,** **2AA****,** **3A****,** **3AA** zeigen jeweils verschiedene bevorzugte Varianten der erfindungsgemässen Anordnung für einen Druckkopf.

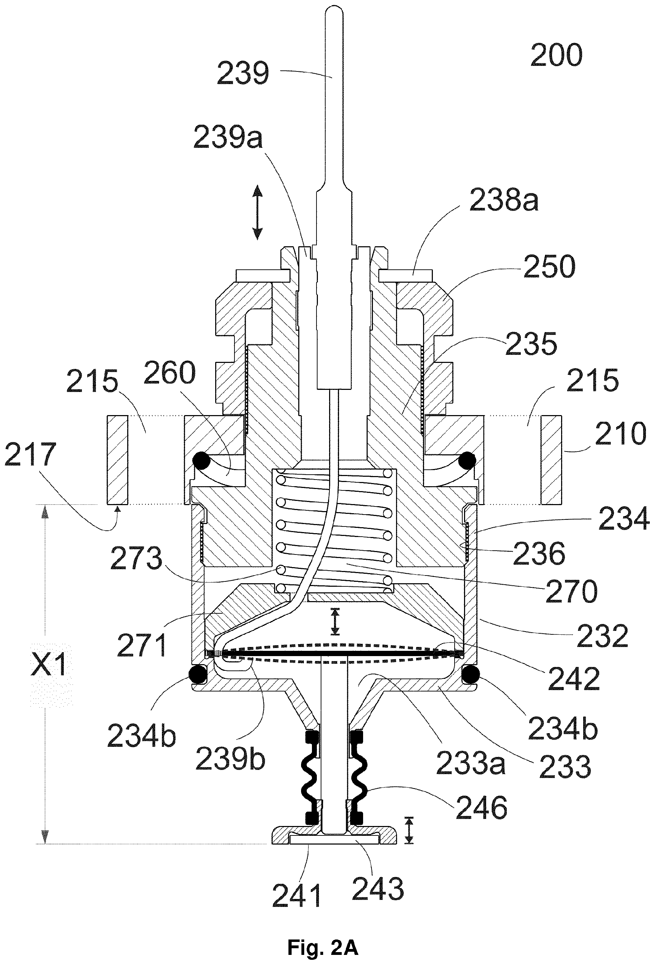

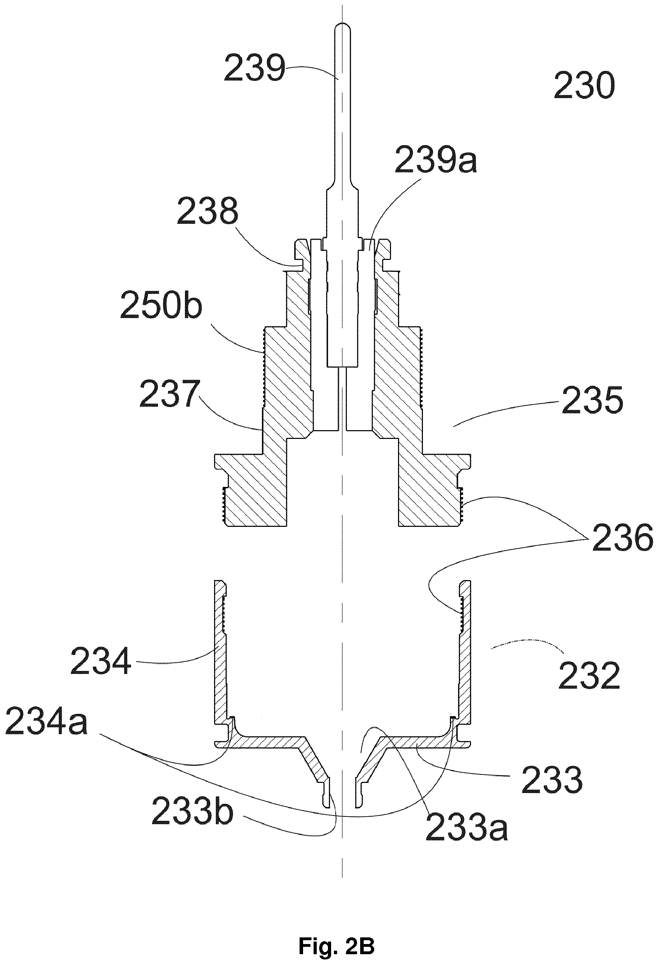

**Figur 2A** zeigt eine bevorzugte erste Variante der erfindungsgemässen Anordnung im Querschnitt, wobei ausgewählte Bestandteile davon der Übersichtlichkeit halber nochmals einzeln oder in einer Gruppe in den **Figuren 2B bis 2E** abgebildet sind, insbesondere zeigt:
   - **Fig. 2B** einen bevorzugten Grundkörper der bevorzugten ersten Variante im Querschnitt in Explosionsansicht;

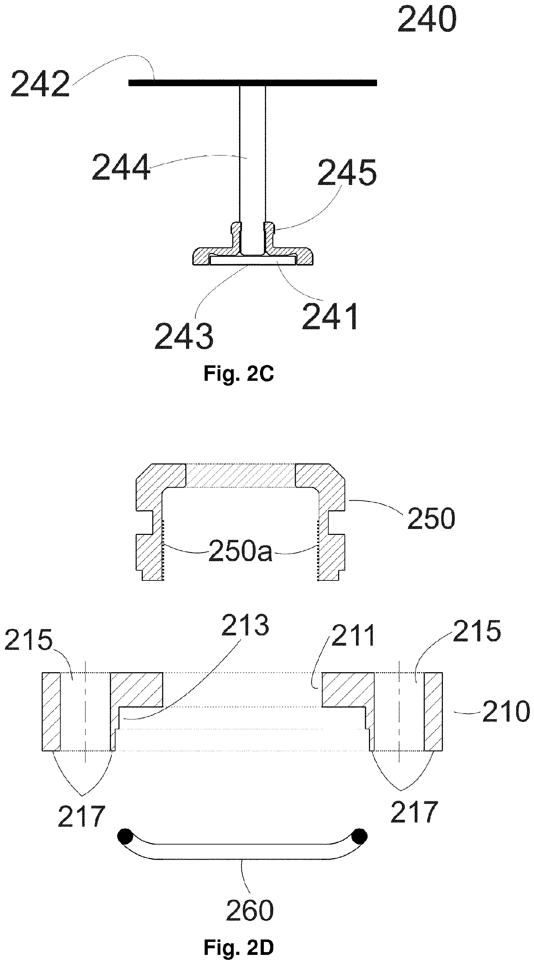

   - **Fig. 2C** bevorzugte erste Mittel zur Bewegung eines Stössels der bevorzugten ersten Variante;
   - **Fig. 2D** unterschiedliche, bevorzugte Komponenten der bevorzugten ersten Variante im Querschnitt;

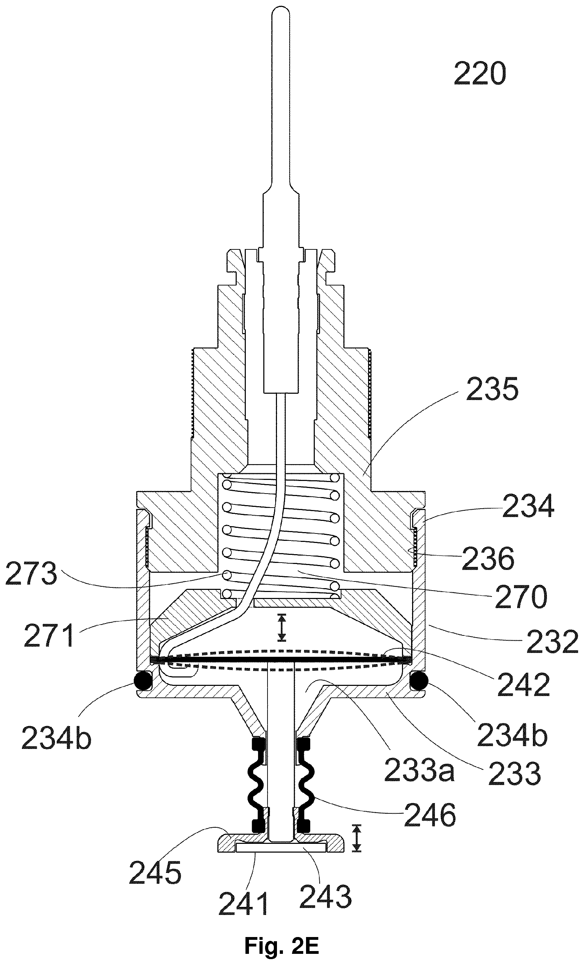

   - **Fig. 2E** eine bevorzugte Aktuatorvorrichtung der bevorzugten ersten Variante im Querschnitt.

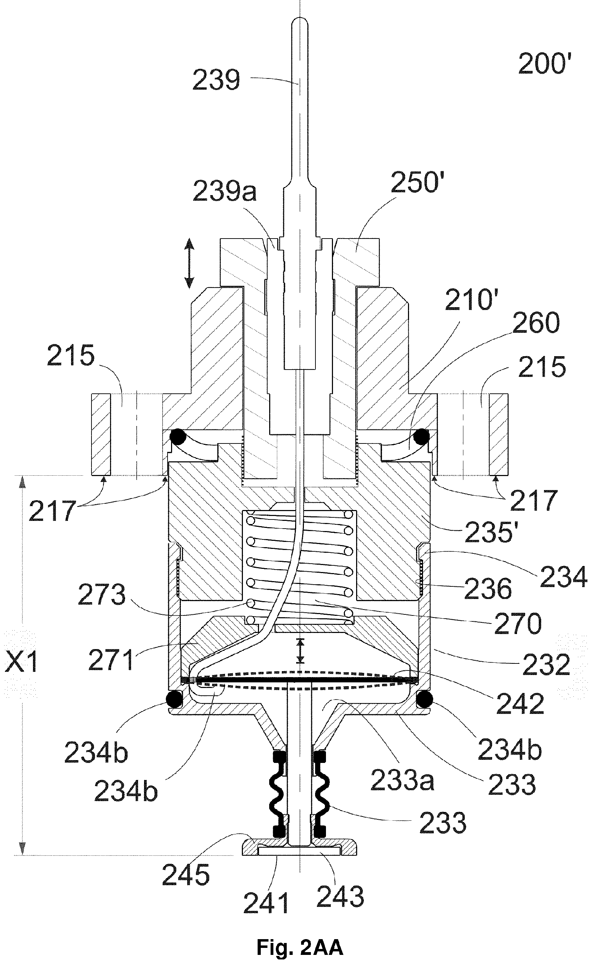

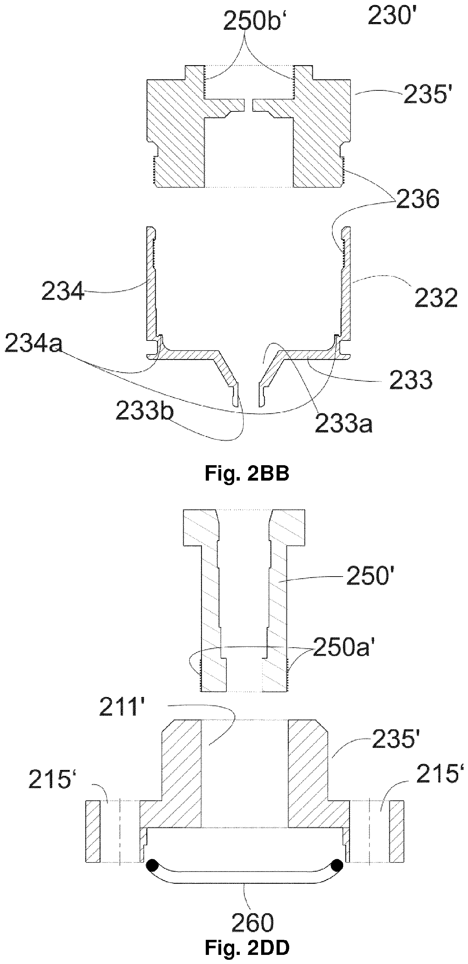

**Figur 2AA** zeigt eine bevorzugte zweite Variante der erfindungsgemässen Anordnung im Querschnitt, wobei ausgewählte Bestandteile davon der Übersichtlichkeit halber nochmals einzeln oder in einer Gruppe in den **Figuren 2BB bis 2EE** abgebildet sind, insbesondere zeigt:
   - **Fig. 2BB** einen bevorzugten Grundkörper der bevorzugten zweiten Variante im Querschnitt in Explosionsansicht;
   - **Fig. 2DD** unterschiedliche, bevorzugte Komponenten der bevorzugten zweiten Variante im Querschnitt;

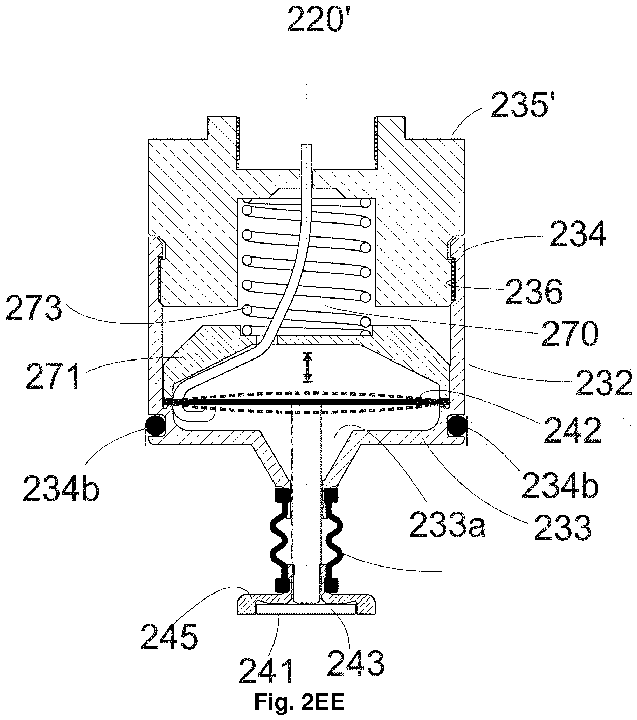

   - **Fig. 2EE** eine bevorzugte Aktuatorvorrichtung der bevorzugten zweiten Variante im Querschnitt.

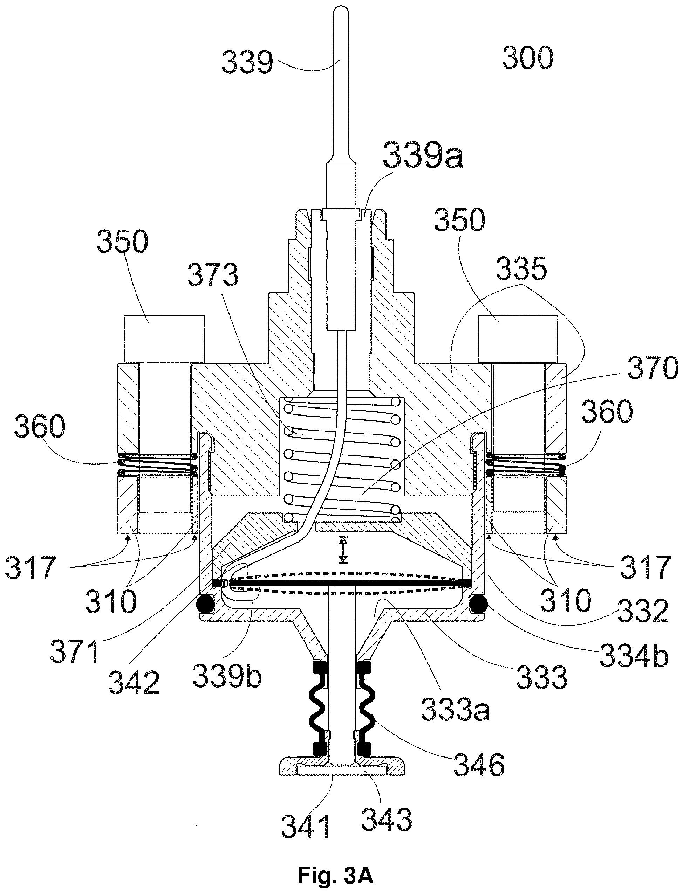

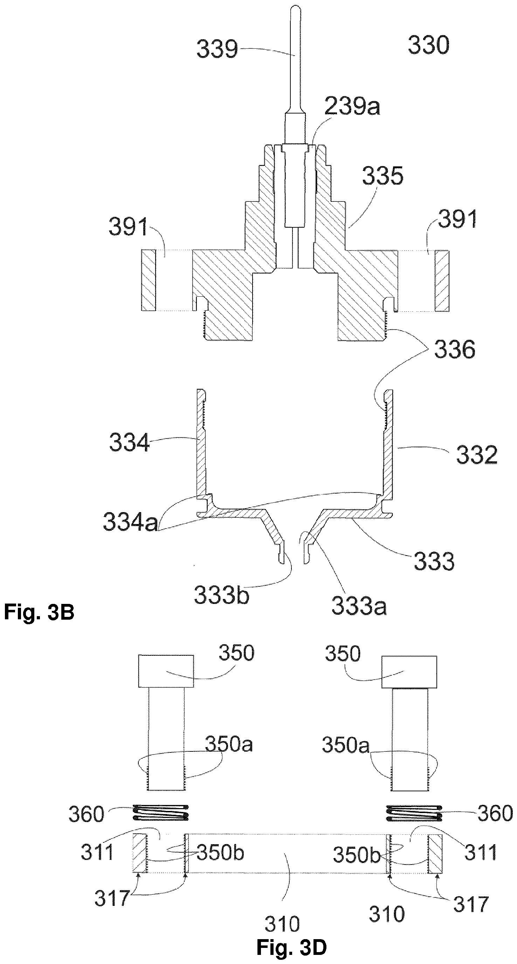

**Figur 3A** zeigt eine bevorzugte dritte Variante der erfindungsgemässen Anordnung im Querschnitt, wobei ausgewählte Bestandteile davon der Übersichtlichkeit halber nochmals einzeln oder in einer Gruppe in den **Figuren 3B und 3D** abgebildet sind, insbesondere zeigt:
   - **Fig. 3B** einen bevorzugten Grundkörper der bevorzugten dritten Variante im Querschnitt in Explosionsansicht;
   - **Fig. 3D** unterschiedliche, bevorzugte Komponenten der bevorzugten dritten Variante im Querschnitt;

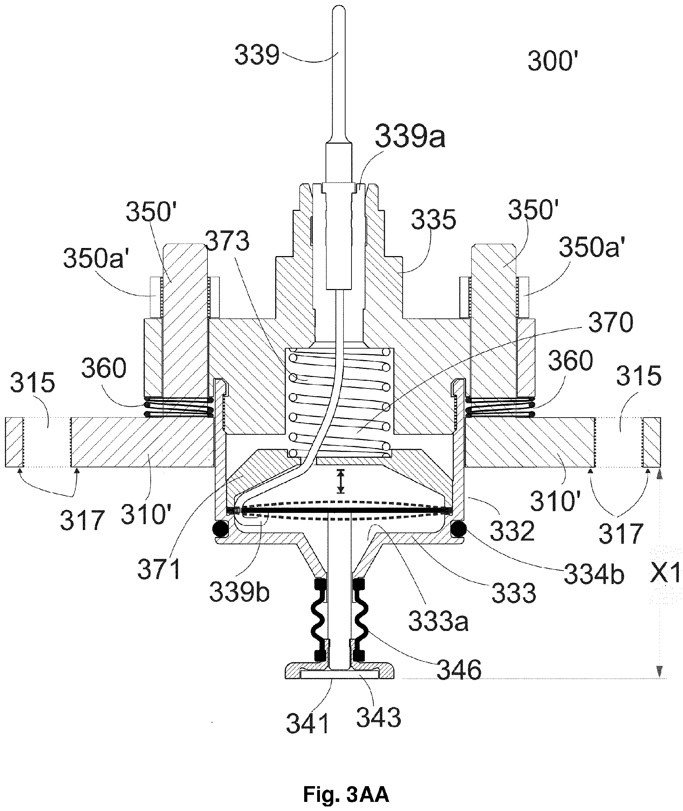

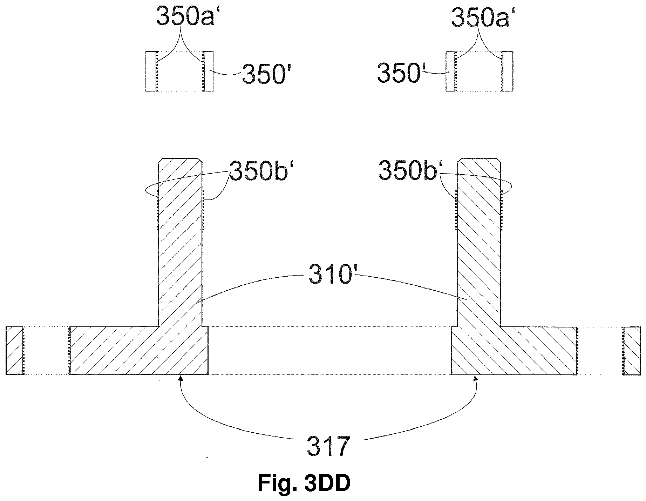

**Figur 3AA** zeigt eine bevorzugte vierte Variante der erfindungsgemässen Anordnung im Querschnitt, wobei ausgewählte Bestandteile davon der Übersichtlichkeit halber nochmals in einer Gruppe in **Figur 3DD** abgebildet sind, insbesondere zeigt:
   - **Fig. 3DD** unterschiedliche, bevorzugte Komponenten der bevorzugten vierten Variante im Querschnitt;

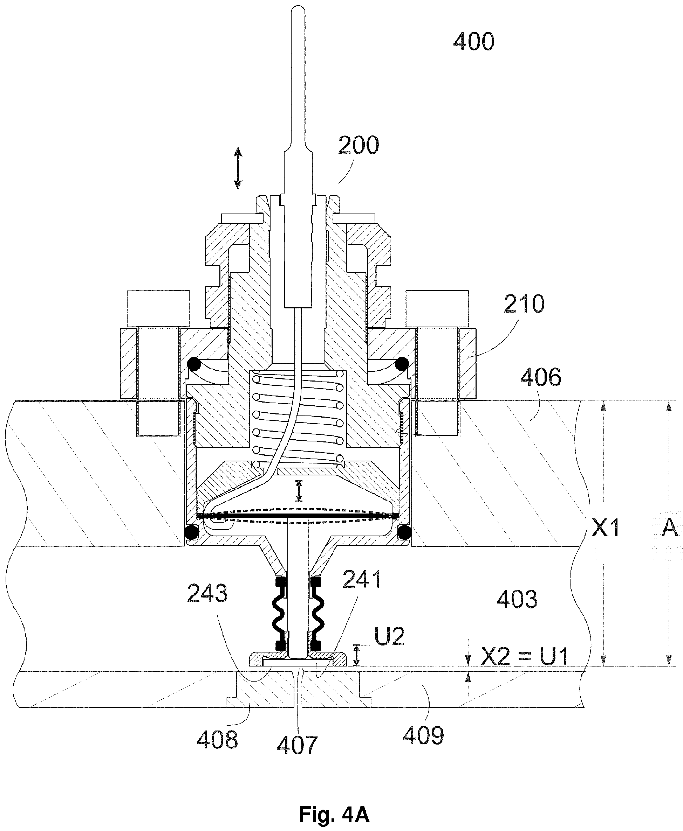

**Figur 4A** zeigt eine bevorzugte erste Variante des erfindungsgemässen Druckkopfes im Querschnitt.

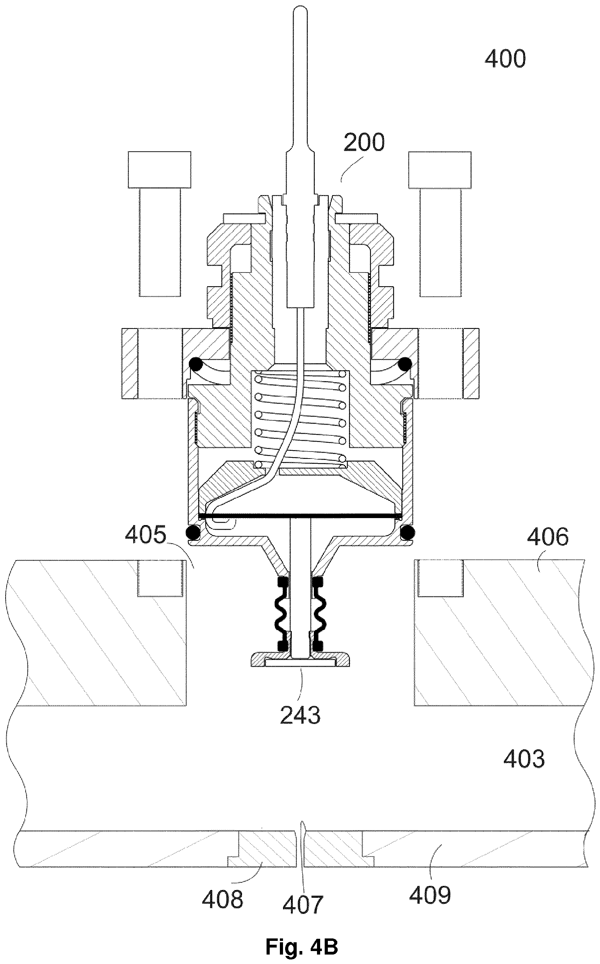

**Figur 4B** zeigt die bevorzugte erste Variante des erfindungsgemässen Druckkopfes aus Fig. 4A im Querschnitt im nicht-angeordneten Zustand.

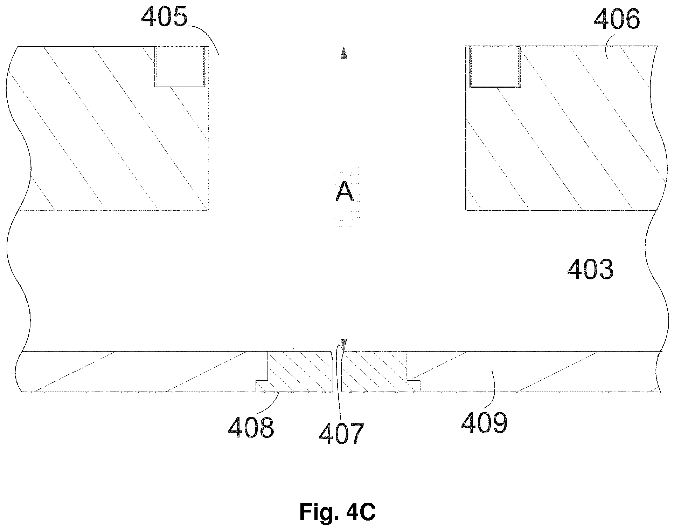

**Figur 4C** zeigt einen Ausschnitt eines Tintenversorgungskanals mit einer Düse, die Teil eines erfindungsgemässen Druckkopfes ist.

**Fig. 1** zeigt eine Anordnung 100 aus der WO 239a03/013983 A1 gemäß dem Stand der Technik.

**Figur 2A** zeigt eine erste bevorzugte Variante der erfindungsgemässen Anordnung 200 für einen Druckkopf im Querschnitt, die die Aktuatorvorrichtung 230 aus **Figur 2E** mit dem Grundkörper 220 aus **Figur 2B****,** den ersten Mittel 240 zur Bewegung der Stösselstirnseite 243 aus **Figur 2C****,** und den bevorzugten Komponenten aus **Figur 2D** umfasst.

In **Figur 2A** ist eine bevorzugte erfindungsgemässe Anordnung 200 für einen Druckkopf abgebildet mit dem Tragkörper 210 aus **Figur 2D** zur Fixierung der Anordnung 200 an einem Druckkopf, ein durch ein Durchgangsloch ("211" aus Fig. 2D) des Tragkörpers 210 hindurch gesteckter und darin gelagerter Grundkörper ("230" aus Fig. 2B) einer Aktuatorvorrichtung ("220": aus Figur 2E) realisiert, der erste Mittel ("240" aus Fig. 2C) umfasst zur Bewegung eines Stössels 241, über die der Stössel 241 am Grundkörper angebracht ist und bei elektrischer Ansteuerung derselben relativ dazu bewegbar ist, wobei der Grundkörper mit einem auf dem Tragkörper 210 gelagertem Element zur Positionierung des Stössels 241 relativ zum Tragkörper 210 in Eingriff steht.

Im Unterschied zur WO2013/013983 A1 ist das Element 250 als Mutter ausgebildet, wobei der Tragkörper 210 und ein erster Abschnitt des Grundkörpers 230 (siehe Figur 2B) als Drehschubgelenk ausgebildet sind (siehe Fig. 2A), das zwei Freiheitsgrade hat und eine Translationsbewegungsrichtung des Grundkörpers definiert, wobei der Grundkörper mit einem Gegengewinde 250b (siehe Fig. 2B) versehen ist, der in der auf und gegenüber dem Tragkörper 210 drehbar gelagerten Mutter eingeschraubt ist und mit dieser ein Schraubgelenk ausbildet, das in Verbindung mit dem Schubgelenk und einem elastischen Element 260 für die Positionierung des Grundkörpers zusammenwirkend so ausgebildet sind, dass der Tragkörper 210 und die Mutter mit einer Vorspannung gegeneinander verklemmt werden und eine Drehung der Mutter eine Bewegung des Grundkörpers 230 relativ zum Tragkörper 210 entlang des einen Translationsfreiheitsgrades und damit eine Änderung eines ersten Istabstandes X1, der als Abstand zwischen einer Stösselstirnseite 243 und der Unterseite 217 des Tragkörpers 210 definiert ist (siehe Figur 2A), bewirkt, um den ersten Istbestand X1 in Bezug auf einen vorgegebenen zweiten Sollabstand S2 einstellen zu können.

**Figur 2B** zeigt eine besonders bevorzugte Ausführungsform des Grundkörpers 230. Dieser umfasst einen Basiskörper 232, der eine Bodenwand 233 mit Durchgangsöffnung 233a einschließt, aus welcher Bodenwand 233 sich eine einen Raum zur Aufnahme eines Stellelements (nicht gezeigt) umschließende Umfangswand 233a erstreckt, und einen Deckel 235 zum Schließen des Basiskörpers 232.

Der Deckel 235 und der Basiskörper 232 können über eine Schraubverbindung als Verbindungsmittel 236 miteinander verbunden werden, wenn der Deckel 235 in einer geschlossenen Position ist (nicht gezeigt).

Der Deckel 235 umfasst einen Verschluss und einen Tragzapfen, wobei sich der Tragzapfen vom Verschluss koaxial weg erstreckt und vorzugsweise einen gegenüber dem Verschluss durchmesserkleinerem ersten Schaft 237 aufweist, der mit dem Gegengewinde 250b versehen ist.

Weiter umfasst der Deckel 235 zumindest einen in eine Durchgangsbohrung des Deckels 235 hineinragenden Elektrodenstift 239 zur elektrischen Verbindung mit einem Stellelement (nicht gezeigt), welcher Elektrodenstift 239 über ein in die Durchgangsbohrung eingesetztes Isolierelement 239a zur elektrischen Isolation des zumindest eines Elektrodenstifts 239 gegenüber dem Deckel 235 mit dem Deckel 235 verbunden ist.

Aus der Bodenwand 233 erstreckt sich ein Hohlschaft 233b weg zur Führung eines Verbindungselements (nicht gezeigt; siehe "244" aus Figur 2C), der die Durchgangsöffnung 233a umfasst. Die Bodenwand 233 des Basiskörpers 232 ist in **Figur 2B** kreisförmig und die Umfangswand 233a zylinderförmig ausgebildet, die beide um eine gemeinsame Rotationsache angeordnet sind.

Die Innenseite der Umfangswand 234 des Basiskörpers 232 umfasst außerdem einen umlaufenden Flansch, der eine Auflage 234a zum Tragen des Stellelements (nicht gezeigt; siehe "242" aus **Figur 2C**) bildet.

Dabei umfasst der Deckel 235 des Grundkörpers 230 in **Figur 2A** zusätzlich:
- ein vom ersten Schaft 237 des Tragzapfens sich weg erstreckender zweiter Zapfen mit einem gegenüber dem ersten Schaft 237 durchmesserkleinerem zweiten Schaft,
- ein vom zweiten Schaft sich weg erstreckender dritter Zapfen mit einem gegenüber dem zweiten Schaft durchmesserkleinerem dritten Schaft,
- wobei der zweite und der dritte Schaft eine gemeinsame, umlaufende Nut (nicht gezeigt; siehe "238" aus **Figur 2B**) umfassen,
- und ein in die Nut einsetzbares Sperrelement 238a zur Begrenzung der Schraubbewegung der Mutter.

**Figur 2C** zeigt eine besonders bevorzugte Ausführungsform der erfindungsgemäßen ersten Mittel 240 zur Bewegung eines Stössels 241.

Die ersten Mittel 240 umfassen ein Stellelement 242und ein längliches Verbindungselement 244, wobei das längliche Verbindungselement 244 am Stössel 241 und am Stellelement 242 angebracht ist.

Das längliche Verbindungselement 244 ist im vorliegenden Fall am Stössel 241 über einen Stösselteller 245 angebracht.

Das Stellelement 242 ist ein Biegewandler, vorzugsweise ein plattenförmiger Biegewandler, der besonders bevorzugt eine zumindest einseitig mit einem piezoelektrischem Körper belegten Tragplatte umfasst, wobei der Biegewandler vorzugsweise kreisförmig ausgebildet ist.

**Figur 2D** zeigt einen Schnitt durch bevorzugte Ausführungsformen unterschiedlicher Komponenten der bevorzugten ersten Variante der erfindungsgemässen Anordnung aus **Figur 2A****.**

In **Figur 2D** ist ein Tragkörper 210 zur Fixierung der Anordnung 200 aus **Figur 2A** an einem Druckkopf ("400": siehe Figur 4) als erste Komponente abgebildet, die ein Durchgangsloch 211 zur Aufnahme des Grundkörpers (nicht gezeigt: siehe "230" aus **Figur 2B****)** umfasst. Als zweite Komponente ist ein als Mutter ausgebildetes Element 250 mit Gewinde 250a abgebildet. Die dritte Komponente betrifft ein elastisches Element 260, das als Drahtfederscheibe ausgebildet ist.

Der Tragkörper 210 ist mit zwei durchgehenden zweiten Durchgangsbohrungen 215 versehen, über die die Anordnung (nicht gezeigt "200" aus **Figur 2A**) vorzugsweise mit entsprechenden Schrauben an einem Druckkopf montierbar ist.

Das erste Durchgangsloch 211 des Tragkörpers 210 ist eine erste durchgehende Bohrung. Der Tragkörper 210 weist zusätzlich eine dritte Bohrung auf, die als erste Sackloch 213 zur Aufnahme des elastischen Elements 260 ausgebildet ist, wobei das erste Durchgangsloch 211 als ein vom ersten Sackloch 213 sich weg erstreckendes erste Durchgangsloch 211 mit einer gegenüber dem ersten Sackloch 213 durchmesserkleineren ersten Bohrung ausgebildet ist, die vorzugsweise zur formschlüssigen Verbindung mit dem ersten Schaft (nicht gezeigt: siehe "237" aus **Figur 2B**) des Tragzapfens ausgebildet ist, wenn der Tragkörper 210 mit dem Grundkörper verbunden ist (siehe **Figur 2A**).

Der Tragkörper 210 weist eine vierte Bohrung auf, die als zweites Sackloch zur formschlüssigen Verbindung mit dem Deckel ("235" aus **Figur 2B**) ausgebildet ist, wobei das erste Sackloch 213 ein vom zweiten Sackloch sich weg erstreckendes erste Sackloch 213 mit einer gegenüber dem zweiten Sackloch durchmesserkleineren dritten Bohrung aufweist.

Alternativ dazu kann der zweite Sackloch und der erste Sackloch 213 als gemeinsames Sackloch mit identischer Bohrung ausgebildet sein.

Die in **Figur 2E** abgebildete bevorzugte Aktuatorvorrichtung 220 der bevorzugten ersten Variante der erfindungsgemässen Anordnung 200 umfasst die ersten Mittel zum Bewegen der Stösselstirnseite 243 aus **Figur 2C** und den bevorzugten Grundkörper aus **Figur 2B****.** Das Stellelement 242 der ersten Mittel zum Bewegen der Stösselstirnseite 243 sind dabei im Basiskörper 232 so gehaltert, dass das Verbindungselement 244 aus dem Basiskörper 232 durch die Durchgangsöffnung 233a hinausragt und sich die Stösselstirnseite 243 außerhalb des Basiskörpers 232 befindet.

Die Innenseite der Umfangswand 234 weist einen umlaufenden Flansch auf, der eine Auflage ("234a": siehe **Fig. 2B**) zum Tragen des Stellelements 242 bildet, wobei die Aktuatorvorrichtung 220 zusätzlich ein kappenförmiges Aufsatzelement 271 umfasst, das mit einer Feder 273 zusammenwirkt, die am Deckel 235 und am Aufsatzelement 271 abstützend angeordnet ist, sodass die Feder 273 und das Aufsatzelement 271 miteinander eine vorbestimmte Kraft gegen den Biegewandler ausüben, wenn der Deckel 235 in der geschlossen Position ist.

Das kappenförmige Aufsatzelement 271 bildet gemeinsam mit der Feder 273, mit der es zusammenwirkt, ein Mittel 270 zur Vorspannung des Stellelements 242 gegen die Auflage 234a mit einer vorbestimmten Kraft, wenn der Deckel 235 geschlossen ist.

Der Basiskörper 232 der Aktuatorvorrichtung 230a in **Figur 2E** umfasst ausserdem an seiner Umfangswand 234 eine radial umlaufende erste Abdichtung 234b, die vorzugsweise aus gummiartigen Material besteht

Zwischen dem Stösselteller 245 und dem Hohlschaft 233b ist eine umlaufende zweite Abdichtung 246, vorzugsweise ein Dichtbalg vorgesehen.

In Figur 2A wurde eine bevorzugte Anordnung 200 für einen Druckkopf offenbart mit einem Tragkörper 210 zur Fixierung der Anordnung 200 am Druckkopf, einer Aktuatorvorrichtung 220 mit einem Grundkörper 230, der durch ein erstes Durchgangsloch 211 des Tragkörpers 210 hindurch gesteckt und darin gelagert ist, wobei die Aktuatorvorrichtung 220 erste Mittel 240 umfasst zur Bewegung eines Stössels 241, über die der Stössel 241 am Grundkörper 230 angebracht ist und bei elektrischer Ansteuerung derselben relativ dazu bewegbar ist, wobei der Grundkörper 230 mit einem auf dem Tragkörper 210 gelagertem Element zur Positionierung des Stössels 241 relativ zum Tragkörper 210 in Eingriff steht.

Das Element 250 ist hier als Mutter ausgebildet, wobei der Tragkörper 210 und ein erster Abschnitt des Grundkörpers 230 als Schubgelenk ausgebildet sind, das einen Translationsfreiheitsgrad hat und eine entsprechende Bewegungsrichtung des Grundkörpers 230 definiert, wobei der Grundkörper 230 mit einem Gegengewinde 250b versehen ist, der in der auf und gegenüber dem Tragkörper 210 drehbar gelagerten Mutter eingeschraubt ist und mit dieser ein Schraubgelenk ausbildet, das in Verbindung mit dem Schubgelenk und einem elastischen Element 309 für die Positionierung des Grundkörpers 230 zusammenwirkend so ausgebildet sind, dass der Tragkörper 210 und die Mutter mit einer Vorspannung gegeneinander verklemmt werden und eine Drehung der Mutter eine Bewegung des Grundkörpers 230 relativ zum Tragkörper 210 entlang des einen Translationsfreiheitsgrades T und damit eine Änderung eines ersten Istabstandes X1, der als Abstand zwischen einer Stösselstirnseite 241 und der Unterseite 217 des Tragkörpers 210 definiert ist, bewirkt, um den ersten Istbestand X1 in Bezug auf einen vorgegebenen zweiten Sollabstand S2 einstellen zu können.

**Figur 2AA** zeigt eine zweite bevorzugte Variante der erfindungsgemässen Anordnung 200' für einen Druckkopf im Querschnitt, die die Aktuatorvorrichtung 230' aus **Figur 2EE** mit dem Basiskörper 220 und mit den ersten Mitteln zur Bewegung der Stösselstirnseite aus **Figuren 2B** **und** **2C** der bevorzugten ersten Variante, und mit den bevorzugten Komponenten aus **Figur 2DD****.**

Wie bei der ersten bevorzugten Variante der Anordnung 200 kennzeichnet sich auch die zweite bevorzugte Variante der Anordnung 200' darin, dass bei beiden Varianten das Element 250, 250' das Gewinde 250a, 250a' und der Grundkörper 230, 230' das Gegengewinde 250b, 250b' umfasst, das in das Gewinde 250a, 250a' eingeschraubt ist, sodass das Element 250, 250' und der Grundkörper 230, 230' das Schraubgelenk bilden, wobei das Schraubgelenk und das zumindest eine elastische Element 260 für die Positionierung der Aktuatorvorrichtung 200, 220' zusammenwirkend so ausgebildet sind, dass der Tragkörper 210, 210' und das Element 250, 250' mit einer Vorspannung gegeneinander verklemmt werden.

Im Unterschied zur bevorzugten ersten Variante ist in der bevorzugten zweiten Variante der erfindungsgemässen Anordnung 200' das Gewinde 250a` des Elements 250' als Aussengewinde ausgebildet und das Gegengewinde 250b' des Grundkörpers 230' als Innengewinde ausgebildet.

Im vorliegenden Fall umfasst das Element 250' der in **Figur 2AA** abgebildeten bevorzugten zweiten Variante einen schraubenförmiger Körper, der mit dem Gewinde 250a' versehen ist. Dabei ist ein zylindrischer Abschnitt des schraubenförmigen Körpers durch das erste Durchgangsloch 211' des Tragkörpers 210' hindurch gesteckt und darin gelagert, und ist in das Gegengewinde 250b' des Deckels 235' des Grundkörpers 230' (siehe Figur 2EE) eingeschraubt, wobei vorzugsweise der zylindrische Abschnitt des Elements 250' mit einer Wandung des ersten Durchgangslochs 235a' des Deckels 235' das Schubgelenk bildet.

**Figur 2BB** zeigt eine besonders bevorzugte Ausführungsform des Grundkörpers 230'. Dieser umfasst den Basiskörper 232 aus **Figur 2B****,** und einen Deckel 235' zum Schließen des Basiskörpers 232.

Der Deckel 235' und der Basiskörper 232 können über eine Schraubverbindung als Verbindungsmittel 236 miteinander verbunden werden, wenn der Deckel 235' in einer geschlossenen Position ist (nicht gezeigt). Der Deckel 235' umfasst einen Verschluss und ein Gegengewinde 235b', der als Innengewinde ausgebildet ist.

In **Figur 2DD** ist ein Tragkörper 210' zur Fixierung der Anordnung aus **Figur 2AA** an einem Druckkopf ("400": siehe Figur 4A) als erste Komponente abgebildet, die ein Durchgangsloch 211' zur Aufnahme des Grundkörpers ("230"" aus **Figur 2BB**) umfasst. Als zweite Komponente ist ein als schraubenförmiger Körper ausgebildetes Element 250' mit Aussengewinde 250a` abgebildet. Die dritte Komponente betrifft ein elastisches Element 260, das als Drahtfederscheibe ausgebildet ist.

Der Tragkörper 210' ist mit zwei durchgehenden zweiten Durchgangsbohrungen 215' versehen, über die die Anordnung ("200"" aus **Figur 2AA**) vorzugsweise mit entsprechenden Schrauben an einem Druckkopf montierbar ist.

Die in **Figur 2EE** abgebildete bevorzugte Aktuatorvorrichtung 220' der bevorzugten zweiten Variante der erfindungsgemässen Anordnung 200' umfasst die ersten Mittel zum Bewegen der Stösselstirnseite 243 aus **Figur 2C** und den bevorzugten Grundkörper aus **Figur 2B****.** Das Stellelement 242 der ersten Mittel zum Bewegen der Stösselstirnseite 243 sind dabei im Basiskörper 232 so gehaltert, dass das Verbindungselement 244 aus dem Basiskörper 232 durch die Durchgangsöffnung 233a hinausragt und sich die Stösselstirnseite 243 außerhalb des Basiskörpers 232 befindet.

**Figuren 3A** **und** **3AA** zeigen eine dritte und eine vierte bevorzugte Variante der erfindungsgemässen Anordnung 300, 300' für einen Druckkopf im Querschnitt.

Sie unterscheiden sich von der ersten und zweiten Variante, bei denen das Element 250, 250' das Gewinde 250a, 250a' und der Grundkörper 230, 230 umfasst, darin, dass nicht der Grundkörper 330, 330', sondern der Tragkörper 310, 310' das Gegengewinde 350b, 350b' umfasst, das in das Gewinde 350a, 350a' eingeschraubt ist, sodass das Element 350, 350' und der Tragkörper 310, 310' das Schraubgelenk bilden, wobei das Schraubgelenk und das zumindest eine elastische Element 360 für die Positionierung der Aktuatorvorrichtung zusammenwirkend so ausgebildet sind, dass der Grundkörper 310, 310' und das Element 350, 350' mit einer Vorspannung gegeneinander verklemmt werden.

**Figur 3A** zeigt die dritte bevorzugte Variante der erfindungsgemässen Anordnung 300 für einen Druckkopf im Querschnitt, die die Aktuatorvorrichtung mit dem Basiskörper 320 aus **Figur 3B****,** die ersten Mittel 340 zur Bewegung der Stösselstirnseite 343, und die bevorzugten Komponenten aus **Figur 3D** umfasst.

Bei der dritten Variante ist das Gewinde 350a des Elements 350 als Aussengewinde ausgebildet und das Gegengewinde 350b des Tragkörpers 310 als Innengewinde ausgebildet, wobei das Element 350 vorzugsweise eine Schraube umfasst, die mit dem Gewinde 350a versehen ist.

Dabei ist jeweils ein zylindrischer Abschnitt zweier Elemente 350 durch jeweils eine Randbohrung 391 des Deckels 335 hindurch gesteckt und darin gelagert, wobei vorzugsweise der jeweilige zylindrische Abschnitt der Elemente 350 mit jeweils einer Wandung der jeweiligen Randbohrung 391 ein Schubgelenk bildet.

**Figur 3B** zeigt eine besonders bevorzugte Ausführungsform des Grundkörpers 330. Dieser umfasst einen Basiskörper 332, der eine Bodenwand 333 mit Durchgangsöffnung 333a einschließt, aus welcher Bodenwand 333 sich eine einen Raum zur Aufnahme eines Stellelements (nicht gezeigt) umschließende Umfangswand 334 erstreckt, und einen Deckel 335 zum Schließen des Basiskörpers 332.

Der Deckel 335 und der Basiskörper 332 können über eine Schraubverbindung als Verbindungsmittel 336 miteinander verbunden werden, wenn der Deckel 335 in einer geschlossenen Position ist (nicht gezeigt).

Der Deckel 335 umfasst einen Verschluss und einen Tragzapfen, wobei sich der Tragzapfen vom Verschluss koaxial weg erstreckt.

Weiter umfasst der Deckel 335 zumindest einen in eine Durchgangsbohrung des Deckels 335 hineinragenden Elektrodenstift 339 zur elektrischen Verbindung mit einem Stellelement, welcher Elektrodenstift 339 über ein in die Durchgangsbohrung eingesetztes Isolierelement 339a zur elektrischen Isolation des zumindest eines Elektrodenstifts 339 gegenüber dem Deckel 335 mit dem Deckel 335 verbunden ist.

Aus der Bodenwand 333 erstreckt sich ein Hohlschaft 333b weg zur Führung eines Verbindungselements, der die Durchgangsöffnung 333a umfasst. Die Bodenwand 333 des Basiskörpers 332 ist in **Figur 3B** kreisförmig und die Umfangswand 334 zylinderförmig ausgebildet, die beide um eine gemeinsame Rotationsache angeordnet sind.

Die Innenseite der Umfangswand 334 des Basiskörpers 332 umfasst außerdem einen umlaufenden Flansch, der eine Auflage 334a zum Tragen des Stellelements ("342" aus **Figur 3A**) bildet.

Der Deckel **in** **Figur 3B** umfasst zwei Randbohrungen 391, durch die zwei Elemente 350 aus **Figur 3D** hindurch gesteckt und darin gelagert werden können.

In **Figur 3D** ist ein Tragkörper 310 zur Fixierung der Anordnung aus **Figur 3A** an einem Druckkopf (siehe "400": siehe **Figur 4**) abgebildet, die zwei erste Durchgangslöcher 311 zur Aufnahme von jeweils einem Element 350 umfasst. In **Figur 3D** sind darüber hinaus noch zwei elastische Elemente 360 abgebildet, die in einer bevorzugten dritten Variante der Anordnung 300 zum Einsatz kommen können.

**Figur 3AA** zeigt die vierte bevorzugte Variante der erfindungsgemässen Anordnung 300' für einen Druckkopf im Querschnitt, die eine Aktuatorvorrichtung mit dem Basiskörper 320 aus **Figur 3B****,** den ersten Mitteln 340 zur Bewegung der Stösselstirnseite 343, und den bevorzugten Komponenten aus **Figur 3DD** umfasst.

Im Unterschied zur dritten Variante der erfindungsgemässen Anordnung 300 ist bei der vierten Variante der erfindungsgemässen Anordnung 300' ein Gewinde 350a` eines Elements 350' als Innengewinde ausgebildet ist und ein Gegengewinde 350b' des Tragkörpers 350' als Aussengewinde ausgebildet. Im vorliegenden Fall umfasst ein Element 350' eine Mutter, die mit dem Gewinde 350a' versehen ist.

In der vorliegenden bevorzugten Ausführungsform sind zwei voneinander getrennte zylindrische Abschnitte des Tragkörpers 310' durch jeweils eine Randbohrung 391 des Grundkörpers 330' hindurch gesteckt und darin gelagert, wobei vorzugsweise der jeweilige zylindrische Abschnitt des Tragkörpers 310' mit jeweils einer Wandung der jeweiligen Randbohrung ("391" aus Figur 3B) das Schubgelenk bildet.

Es wurde eine Anordnung 200, 200', 300, 300' für einen Druckkopf angegeben mit einem Tragkörper 210, 210', 310, 310' zur Fixierung der Anordnung 200, 200', 300, 300' am Druckkopf, einer Aktuatorvorrichtung 220, 220', 330, 330' mit einem Grundkörper 230, 230', 330, 330', der am Tragkörper 210, 210', 310, 310' angebracht ist, wobei die Aktuatorvorrichtung 220, 220', 330, 330'erste Mittel 240, 340 umfasst zur Bewegung eines Stössels 241, 341, über die der Stössel 241, 341 am Grundkörper 230, 230', 330, 330' angebracht ist und bei Ansteuerung derselben relativ dazu bewegbar ist, wobei der Grundkörper 230, 230', 330, 330' mit einem Element 250, 250', 350, 350' zur Positionierung der Aktuatorvorrichtung 220, 220', 320, 320' relativ zum Tragkörper 210, 210', 310, 310' wirkverbunden ist.

Erfindungsgemäss kennzeichnet sich die Anordnung 200, 200', 300, 300' darin, dass sie zusätzlich umfasst:
- ein Schraubgelenk, das so ausgebildet ist, dass über dieses der Grundkörper 230, 230', 330, 330' am Tragkörper 210, 210', 310, 310' beweglich anbringbar ist, wobei das Schraubgelenk ein Gewinde 250a, 250a', 350a, 350a' und ein Gegengewinde 250b, 250b', 350b, 350b' umfasst, das in das Gewinde 250a, 250a', 350a, 350a' einschraubbar ist,
- zumindest ein elastisches Element 260, 360,
- wobei das Schraubgelenk und das zumindest eine elastische Element 260, 360 für die Positionierung der Aktuatorvorrichtung 220, 220', 320, 320' zusammenwirkend so ausgebildet sind, dass das Gewinde 250a, 250a', 350a, 350a' und das Gegengewinde 250b, 250b', 350b, 350b' mit einer Vorspannung gegeneinander verklemmt werden und dass bei Betätigung des Schraubgelenks eine Bewegung des Grundkörpers 230, 230', 330, 330' relativ zum Tragkörper 210, 210', 310, 310' entlang einer Translationsrichtung bewirkt wird.

Durch die Drehung des Elements 250, 250', 350, 350' wird somit eine Änderung eines ersten Istabstandes X1, der als Abstand zwischen einer Stösselstirnseite 243, 343 und einer Unterseite 217, 317 des Tragkörpers 210, 210', 310, 310' definiert ist, bewirkt, um den ersten Istbestand X1 in Bezug auf einen vorgegebenen zweiten Sollabstand S2 einstellen zu können.

Erfindungsgemäß umfasst die Anordnung 200, 200', 300, 300' zusätzlich:
- ein Schubgelenk zum Führen des Grundkörpers 230, 230', 330, 330' relativ zum Tragkörper 210, 210', 310, 310' entlang der Translationsrichtung.

Das Schubgelenk der Anordnung 200, 200', 300, 300' kann als Drehschubgelenk mit einem zusätzlichen, rotatorischen Freiheitsgrad ausgebildet sein.

Das elastische Element 260, 360 der Anordnung 200, 200', 300, 300' kann am Tragkörper 210, 210', 310, 310' und am Grundkörper 230, 230', 330, 330' abstützend wirksam sein.

Das Gewinde 250a, 250a', 350a, 350a' und das Gegengewinde 250b, 250b', 350b, 350b' der Anordnung 200, 200', 300, 300' können jeweils als Feingewinde ausgebildet sein.

Das elastische Element 260, 360 der Anordnung 200, 200', 300, 300' kann eine Federscheibe, vorzugsweise eine Drahtfederscheibe sein und jeweils vorzugsweise aus Metall gebildet sein.

Der Tragkörper 210, 210', 310, 310' der Anordnung 200, 200', 300, 300' kann mit mindestens einer zweiten Durchgangsbohrung 215, 315 versehen sein.

In einer bevorzugten Ausführungsform des Grundkörpers 230, 230', 330, 330' umfasst der Grundkörper 230, 230', 330, 330':
- einen Basiskörper 232, 332 mit einer Bodenwand 233, 333, die eine Durchgangsöffnung 233a, 333a einschließt, aus welcher Bodenwand 233, 333 sich eine einen Raum zur Aufnahme eines Stellelements 242, 342 umschließende Umfangswand 234, 334 erstreckt,
- einen Deckel 235, 235', 335 zum teilweise oder vollständigen Schließen des Basiskörpers 232, 332, wobei Deckel 235, 235', 335 und Basiskörper 232, 332 über Verbindungsmittel 236, 336, die bevorzugt als Schraubverbindung ausgebildet sind, miteinander verbindbar sind,
- wobei die ersten Mittel 240, 340 ein Stellelement 242, 342 und ein längliches Verbindungselement 244, 344 umfassen,
- wobei das Verbindungselement 244, 344 am Stössel 241, 341 und am Stellelement 242, 342 angebracht ist,
- wobei das Stellelement 242, 342 im Basiskörper 232, 332 so gehaltert ist, dass das Verbindungselement 244, 344 aus dem Basiskörper 232, 332 durch die Durchgangsöffnung 233a, 333a hinausragt und sich die Stösselstirnseite 243, 343 außerhalb des Basiskörpers 232, 332 befindet.

In einer weiteren bevorzugten Ausführungsform der erfindungsgemässen Anordnung 200, 200', 300, 300' können eines oder mehrere folgender Bestandteile einer Anordnung 200, 200', 300, 300' ausgewählt aus der Gruppe bestehend aus: Tragkörper 210, 210', 310, 310', Element 250, 250', 350, 350', Bodenwand 233, 333, Umfangswand 234, 334 und Deckel 235, 235', 335 aus Metall, vorzugsweise aus Stahl, besonders bevorzugt aus Edelstahl gefertigt sein, und im Falle "mehrerer" aus demselben Metall oder Stahl oder Edelstahl gefertigt sind.

In einer besonders bevorzugten Ausführungsform der Anordnung 200, 200', 300, 300' umfasst das Stellelement 242, 342 einen Biegewandler, vorzugsweise einen plattenförmigen Biegewandler, der der besonders bevorzugt eine zumindest einseitig mit einem piezoelektrischem Körper belegten Tragplatte umfasst, wobei der Biegewandler vorzugsweise kreisförmig ausgebildet ist.

In einer anderen besonders bevorzugten Ausführungsform der Anordnung 200, 200', 300, 300' umfasst das Stellelement 242, 342 einen plattenförmigen Biegewandler, der eine beidseitig mit jeweils einem piezoelektrischem Körper belegten Tragplatte umfasst, wobei der Biegewandler vorzugsweise kreisförmig ausgebildet ist.

In einer weiteren besonders bevorzugten Ausführungsform der Anordnung 200, 200', 300, 300' ist das Stellelement 242, 342 so ausgebildet ist, dass der Stössels 241, 341 mit einem Richtungswechsel des Stössels 241, 341 am Umkehrpunkt (U1) mit einer Frequenz von mindestens 1,0 kHz, vorzugsweise mindestens 1,1 kHz, besonders bevorzugt von mindestens 1,2 kHz arbeiten kann.

In der erfindungsgemäßen Ausführungsform der Anordnung, ist das elastische Element 260, 360 so stark ausgebildet, dass der Tragkörper 210, 210', 310, 310' oder der Grundkörper 230, 230', 330, 330' und das Element 250, 250', 350, 350' mit einer solch starken Vorspannung gegeneinander verklemmt werden, dass die Betätigung des Schraubgelenks nur mittels eines technischen Hilfsmittels, vorzugsweise eines geeigneten Schraubenschlüssels, durchführbar ist. Bei dieser Ausführungsform lässt sich also das Schraubgelenk händisch, d.h. mit den blossen Händen und ohne technische Hilfsmittel, nicht drehen.

Die technische Wirkung dieses Unterschiedsmerkmals liegt darin, dass selbst dann, wenn der Basiskörper in eine Einsetzung einer Seitenwand eines Tintenversorgungskanals eines erfindungsgemässen Druckkopfes formschlüssig eingesetzt ist, bei Betätigung des Schraubgelenks die zwischen der Seitenwand und dem Basiskörper vorherrschenden Reibungskräfte überwunden werden können, sodass der Basiskörper und damit der Grundkörper entlang der Translationsrichtung unmittelbar bewegbar ist.

In einer ganz besonders bevorzugten Ausführungsform ist die Mutter als Sechskantmutter ausgebildet, wobei der Schraubenschlüssel vorzugsweise als Sechskantschraubenschlüssel ausgebildet ist.

Die Bodenwand 233, 333 der Anordnung 200, 200', 300, 300' kann kreisförmig und die Umfangswand 234, 334 zylinderförmig ausgebildet sein, die beide um eine gemeinsame Rotationsache angeordnet sein können.

In einer besonders bevorzugten Ausführungsform des Grundkörpers 230, 230', 330, 330' umfasst der Grundkörper 230, 230', 330, 330' eine Auflage 234a, 334a zum Tragen des Stellelements 242, 342 und zweite Mittel zur Vorspannung 270 des Stellelements 242, 342 gegen die Auflage 234a, 334a, die das Stellelement 242, 342 mit einer vorbestimmten Kraft gegen die Auflage 234a, 334a drückt, wenn der Deckel 235, 235', 335 in der geschlossenen Position ist.

Die Innenseite der Umfangswand 234, 334 des Basiskörpers 232, 332 kann einen umlaufenden Flansch aufweisen, der die Auflage 234a, 334a umfasst.

In einer bevorzugten Ausführungsform der Anordnung 200, 200', 300, 300' sind die zweiten Mittel zur Vorspannung 270, 370 so ausgebildet, dass die vorbestimmte Kraft auf das Stellelement 242, 342 entlang zumindest eines Teils seines Umfangs, vorzugsweise entlang seines gesamten Umfang ausgeübt wird, wenn der Deckel 235, 235', 335 in der geschlossenen Position ist.

In einer besonders bevorzugten Ausführungsform der Anordnung 200, 200', 300, 300' umfassen die Mittel zur Vorspannung 270, 370 ein kappenförmiges Aufsatzelement 271, 371, das vorzugsweise aus Polymer oder Gummi besteht, und mit einer Feder 273, 373 zusammenwirkt, die am Deckel 235, 235', 335 und am Aufsatzelement 271, 371 abstützend angeordnet ist, sodass die Feder 273, 373 und das Aufsatzelement 272, 372 miteinander eine vorbestimmte Kraft gegen das Stellelement 242, 342 ausüben, wenn der Deckel 235, 235', 335 geschlossen ist.

Der Basiskörper 232, 332 kann an seiner Umfangswand 234, 334 eine radial umlaufende erste Abdichtung 234b, 334b umfassen.

In einer bevorzugten Ausführungsform der Anordnung 200, 200', 300, 300' umfasst der Stössel 241, 341 zusätzlich einen Stösselteller 245, 345, wobei das längliche Verbindungselement 244, 344 am Stössel 241, 341 über den Stösselteller 245, 345 angebracht ist.

In einer besonders bevorzugten Ausführungsform des Grundkörpers 230, 230', 330, 330' erstreckt sich aus der Bodenwand 233, 333 ein Hohlschaft 233b, 333b, der die Durchgangsöffnung 233a, 333a umfasst, wobei das längliche Verbindungselement 244, 344 zumindest abschnittsweise in dem Hohlschaft 233b, 333b parallel zu einer Längsmittelgeraden des Hohlschafts 233b, 333b bewegbar geführt sein kann, wobei zwischen dem länglichen Verbindungselement 244, 344 oder dem Stösselteller 245, 345 und dem Hohlschaft 233b, 333b eine vorzugsweise radial umlaufende zweite Abdichtung 246, 346, insbesondere ein Dichtbalg vorgesehen ist.

Gemäß einer bevorzugten Ausführungsform der bevorzugten ersten und zweiten Variante der Anordnung 200, 200' umfasst das Element 250, 250' das Gewinde 250a, 250a' und der Grundkörper 230, 230' das Gegengewinde 250b, 250b', das in das Gewinde 250a, 250a' einschraubbar ist, wobei das Schraubgelenk und das zumindest eine elastische Element 260 für die Positionierung der Aktuatorvorrichtung 220, 220' zusammenwirkend so ausgebildet sind, dass der Tragkörper 210, 210' und das Element 250, 250' mit einer Vorspannung gegeneinander verklemmt werden.

Gemäß einer besonders bevorzugten Ausführungsform der bevorzugten ersten Variante der Anordnung 200 ist das Gewinde 250a des Elements 250 als Innengewinde ausgebildet und das Gegengewinde 250b des Grundkörpers 230 als Aussengewinde ausgebildet, wobei das Element 250 vorzugsweise eine Mutter umfasst, die mit dem Gewinde 250a versehen ist.

Gemäß einer weiteren besonders bevorzugten Ausführungsform der bevorzugten ersten Variante der Anordnung 200 ist ein Abschnitt des Grundkörpers 230 durch ein erstes Durchgangsloch 211 des Tragkörpers 210 hindurch gesteckt und darin gelagert, wobei vorzugsweise der Abschnitt des Grundkörpers 230 mit einer Wandung des ersten Durchgangslochs 211 das Schubgelenk bildet.

Gemäß einer anderen besonders bevorzugten Ausführungsform der bevorzugten ersten Variante der Anordnung 200 umfasst der Deckel 235 einen Verschluss und einen Tragzapfen, wobei sich der Tragzapfen vom Verschluss koaxial weg erstreckt und vorzugsweise einen gegenüber dem Verschluss durchmesserkleinerem ersten Schaft 237 aufweist, der mit dem Gegengewinde 250b versehen ist.

Gemäß einer ganz besonders bevorzugten Ausführungsform der bevorzugten ersten Variante der Anordnung 200 weist das erste Durchgangsloch 211 des Tragkörpers 210 eine erste durchgehende Bohrung auf und der Tragkörper 210 eine zweite Bohrung auf, die als erstes Sackloch 213 zur Aufnahme des elastischen Elements 260 ausgebildet ist, wobei das Durchgangsloch 211 ein vom ersten Sackloch 213 sich weg erstreckendes erstes Durchgangsloch 211 mit einer gegenüber dem ersten Sackloch 213 durchmesserkleineren ersten Bohrung ausgebildet ist, die vorzugsweise zur formschlüssigen Verbindung mit dem ersten Schaft 237 des Tragzapfens ausgebildet ist.

Gemäß einer weiteren ganz besonders bevorzugten Ausführungsform der bevorzugten ersten Variante der Anordnung 200 umfasst die Anordnung 200 zusätzlich:
- ein vom ersten Schaft des Tragzapfens sich weg erstreckender zweiter Zapfen mit einem gegenüber dem ersten Schaft durchmesserkleinerem zweiten Schaft,
- ein vom zweiten Schaft sich weg erstreckender dritter Zapfen mit einem gegenüber dem zweiten Schaft durchmesserkleinerem dritten Schaft,
- wobei der zweite und der dritte Schaft eine gemeinsame, umlaufende Nut (238) umfassen,
- ein in die Nut 238 einsetzbares Sperrelement 238a zur Begrenzung der Schraubbewegung des Elements 250.

Gemäß einer besonders bevorzugten Ausführungsform der bevorzugten zweiten Variante der Anordnung 200' ist das Gewinde 250a` des Elements 250' als Aussengewinde ausgebildet und das Gegengewinde 250b' des Grundkörpers 230 als Innengewinde ausgebildet ist, wobei das Element 250' vorzugsweise einen schraubenförmigen Körper umfasst, der mit dem Gewinde 250a' versehen ist.

Gemäß einer weiteren besonders bevorzugten Ausführungsform der bevorzugten zweiten Variante der Anordnung 200' ist ein zylindrischer Abschnitt des Elements 250' durch ein erstes Durchgangsloch 211' des Tragkörpers 210' hindurch gesteckt und darin gelagert, wobei vorzugsweise ein zylindrische Abschnitt des Tragkörpers 210' mit einer Wandung des ersten Durchgangslochs 211' das Schubgelenk bildet.

Gemäß einer bevorzugten Ausführungsform der bevorzugten dritten und vierten Variante der Anordnung 300, 300' umfasst das Element 350, 350' das Gewinde 350a, 350a' und der Tragkörper 310, 310' das Gegengewinde 350b, 350b', das in das Gewinde 350a, 350a' eingeschraubt ist, sodass das Element 350, 350' und der Tragkörper 310, 310' das Schraubgelenk bilden, wobei das Schraubgelenk und das zumindest eine elastische Element 360 für die Positionierung der Aktuatorvorrichtung 320, 320' zusammenwirkend so ausgebildet sind, dass der Grundkörper 310, 310' und das Element 350, 350' mit einer Vorspannung gegeneinander verklemmt werden.

Gemäß einer besonders bevorzugten Ausführungsform der bevorzugten dritten Variante der Anordnung 300 ist das Gewinde 350a des Elements 350 als Aussengewinde ausgebildet und das Gegengewinde 350b des Tragkörpers 310 als Innengewinde ausgebildet, wobei das Element 350 vorzugsweise eine Schraube umfasst, die mit dem Gewinde 350a versehen ist.

Gemäß einer weiteren besonders bevorzugten Ausführungsform der bevorzugten dritten Variante der Anordnung 300 ist ein zylindrischer Abschnitt des Elements 350 durch eine Randbohrung 391 des Deckels 335 hindurch gesteckt und darin gelagert, wobei vorzugsweise der zylindrische Abschnitt des Elements 350 mit einer Wandung der Randbohrung 391 das Schubgelenk bildet.

Gemäß einer besonders bevorzugten Ausführungsform der bevorzugten vierten Variante der Anordnung 300' ist das Gewinde 350a` des Elements 350' als Innengewinde ausgebildet und das Gegengewinde 350b' des Tragkörpers 350' als Aussengewinde ausgebildet, wobei das Element 350' vorzugsweise eine Mutter umfasst, die mit dem Gewinde 350a' versehen ist.

Gemäß einer weiteren besonders bevorzugten Ausführungsform der bevorzugten vierten Variante der Anordnung 300' ist ein zylindrischer Abschnitt des Tragkörpers 310' durch eine Randbohrung 391 des Deckels 335' hindurch gesteckt und darin gelagert, wobei der zylindrische Abschnitt des Tragkörpers 310' mit einer Wandung der Randbohrung 391' das Schubgelenk bildet.

Gemäß einer besonders bevorzugten Ausführungsform der bevorzugten ersten, zweiten und dritten Variante der Anordnung 200, 200', 300 ist die Anordnung 200, 200', 300 so ausgebildet, dass das Gewinde 250a, 250a', 350a des Elements 250a, 250a', 350a direkt als Teil des Schubgelenks wirksam wird.

Gemäß einer besonders bevorzugten Ausführungsform der bevorzugten ersten, dritten und vierten Variante der Anordnung 200, 300, 300' umfasst der Deckel 235, 335, 335' zumindest ein in eine Durchgangsbohrung des Deckels 235, 335 hineinragenden Elektrodenstift 239, 339 zur elektrischen Verbindung mit dem Stellelement 242, 342, der über ein in die Durchgangsbohrung 261, 361 eingesetztes Isolierelement 239a, 339a zur elektrischen Isolation des zumindest eines Elektrodenstifts 239, 339 gegenüber dem Deckel 235, 335 mit dem Deckel 235, 335 verbunden ist.

Gemäß einer weiteren besonders bevorzugten Ausführungsform der bevorzugten zweiten Variante der Anordnung 200' umfasst das Element 250' zumindest ein in eine Durchgangsbohrung des Elements 250' hineinragenden Elektrodenstift 239 zur elektrischen Verbindung mit dem Stellelement 242, der über ein in die Durchgangsbohrung eingesetztes Isolierelement 239a zur elektrischen Isolation des zumindest eines Elektrodenstifts239) gegenüber dem Element 250 mit dem Element 250 verbunden ist.

Gemäß einer anderen besonders bevorzugten Ausführungsform der bevorzugten ersten, zweiten, dritten und vierten Variante der Anordnung 200, 200', 300, 300' ist der zumindest eine Elektrodenstift 239, 339 über einen elektrisch leitenden Kabel 239b, 339b mit dem Stellelement 242, 342 elektrisch verbunden.

Gemäß einer alternativen Ausführungsform der bevorzugten ersten, zweiten, dritten und vierten Variante der Anordnung 200, 200', 300, 300' ist der Tragkörper 210, 210', 310, 310' Teil eines erfindungsgemässen Druckkopfes.

**Figur 4A** zeigt eine bevorzugte Ausführungsform des erfindungsgemässen Druckkopfes, der die bevorzugte erste Variante der erfindungsgemässen Anordnungen 200 und einen Tintenversorgungskanal 403 umfasst, an dem die erfindungsgemässe Anordnung 200 angeordnet ist. Der Druckkopf kann jedoch anstatt der bevorzugten ersten Variante der Anordnung 200 genauso bevorzugte zweite, dritte oder vierte Varianten der erfindungsgemässen Anmeldung 200', 300, 300' oder andere Varianten umfassen.

Figur 4 zeigt einen Druckkopf 400 für einen Tintenstrahldrucker, wobei der Druckkopf 400 zumindest einen Tintenversorgungskanal 403 und zumindest eine Düse 408 mit Düsenkanal und Einströmöffnung 407 aufweist, wobei durch die Einströmöffnung 407 Tinte aus dem Tintenversorgungskanal 403 in den Düsenkanal gepresst und aus diesem ausgestoßen werden kann, wobei die Düse 408 ortsfest an einer Seitenwand 409 des Tintenversorgungskanals 403 angeordnet ist.

Der zumindest einen Düse 408 ist ein Stössel 241 mit im Tintenversorgungskanal 403 liegender Stösselstirnseite 243, die der Einströmöffnung 407 beabstandet gegenüber liegt, zugeordnet.

Der Druckkopf 400 umfasst die ersten Mittel aus **Figur 2C** zum Bewegen der Stösselstirnseite 243 in dem Tintenversorgungskanal 403 zwischen einem von der Einströmöffnung 407 der Düse 408 minimal beabstandeten Umkehrpunkt U1 und einem von der Einströmöffnung 408 der Düse 408 maximal beabstandeten Umkehrpunkt U2 wobei die ersten Mittel die Bewegung einer Stösselstirnseite 243 auf eine Bewegung zwischen den Umkehrpunkten (U1, U2) begrenzen.

Gemäss einer bevorzugten Ausführungsform des Druckkopfes 400 umfasst der Druckkopf zweite Mittel zum Beaufschlagen der Tinte im Tintenversorgungskanal 403 mit einem Unterdruck relativ zum Umgebungsluftdruck.

Der Druckkopf 400 umfasst eine der Seitenwand 409 gegenüberliegende Trägerseitenwand 406 zur Ablage des Tragkörpers 210 der erfindungsgemässen Anordnung 200, welche Trägerseitenwand 406 eine Einsetzöffnung 405 zur Aufnahme eines Grundkörpers 230 einer Aktuatorvorrichtung 230 der erfindungsgemässen Anordnung 200 umfasst.

Die ersten Mittel zur Bewegung der Stösselstirnseite 243 sind Teil einer ersten bevorzugten Variante der erfindunggemässen Anordnung 200, die am Druckkopf 400 so angeordnet und eingestellt ist, dass durch Betätigung des Schraubgelenks eine Bewegung des Grundkörpers 230 relativ zum Tragkörper 210 entlang der einen Translationsrichtung und damit eine Änderung eines ersten Istabstandes X1 bewirkt wird, um den ersten Istbestand X1 in Bezug auf einen vorgegebenen zweiten Sollabstand S2 einstellen zu können.

Der vorgegebene zweite Sollabstand S2 entspricht in **Figur 4A** dem Abstand zwischen der Stösselstirnseite 243 und der Einströmöffnung 407 der Düse am minimal beabstandeten Umkehrpunkt U1.

Der minimal beabstandeten Umkehrpunkt U1 kann seinerseits unter Berücksichtigung der oben genannten unterschiedlichen Faktoren, die den Druckvorgang eines Substrates beeinflussen, definiert werden.

Der Abstand A ist, wie einleitend bereits definiert, auch in **Figur 4A** als Abstand zwischen der Einsetzöffnung 405 (siehe Figur 4C) der Trägerseitenwand 406 des Tintenversorgungskanals 403 und der Einströmöffnung 407 der Düse 408 definiert, wobei die Trägerseitenwand 406 als die der Einströmöffnung 407 der Düse 408 gegenüberliegende Seitenwand des Tintenversorgungskanals 403 des Druckkopfes 403 definiert ist.

Somit entspricht hier der Abstand A der Summe aus erstem Istabstand X1 und zweitem Istabstand X2.

Es wurde ein Druckkopf 400 für einen Tintenstrahldrucker offenbart, wobei der Druckkopf 400 zumindest einen Tintenversorgungskanal 403 und zumindest eine Düse 408 mit Düsenkanal und Einströmöffnung 407 aufweist, wobei durch die Einströmöffnung 407 Tinte aus dem Tintenversorgungskanal 403 in den Düsenkanal gepresst und aus diesem ausgestoßen werden kann, wobei die Düse 408 ortsfest an einer Seitenwand 409 des Tintenversorgungskanals 403 angeordnet ist und der zumindest einen Düse 408 ein Stössel 241, 341 mit im Tintenversorgungskanal 403 liegender Stösselstirnseite 243, 343, die der Einströmöffnung 407 beabstandet gegenüber liegt, zugeordnet ist, wobei der Druckkopf 400 erste Mittel umfasst zum Bewegen der Stösselstirnseite 243, 343 in dem Tintenversorgungskanal 403 zwischen einem von der Einströmöffnung 407 der Düse 408 minimal beabstandeten Umkehrpunkt U1 und einem von der Einströmöffnung 408 der Düse 408 maximal beabstandeten Umkehrpunkt U2 wobei die ersten Mittel die Bewegung einer Stösselstirnseite 407 auf eine Bewegung zwischen den Umkehrpunkten (U1,U2) begrenzen, wobei der Druckkopf 400 eine der Seitenwand 409 gegenüberliegende Trägerseitenwand 406 zur Ablage einer Tragkörpers 210, 210', 310, 310' umfasst, welche Trägerseitenwand 406 eine Durchgangsöffnung 405 zur Aufnahme eines Grundkörpers 230, 330 einer Aktuatorvorrichtung 220, 220', 320, 320' umfasst.

Erfindungsgemäss umfasst der Druckkopf 400 eine erfindungsgemässe Anordnung 200, 200', 300, 300', die am Tintenversorgungskanal 403 angeordnet ist und mit diesem verbunden ist, wobei die ersten Mittel 240, 340 zur Bewegung der Stösselstirnseite 243, 343 Teil der erfindungsgemässen Anordnung 200, 200', 300, 300' sind.

Vorteilhaft ist, dass durch Betätigung des Schraubgelenks, vorzugsweise durch Drehung des Elements 250, 250', 350, 350', eine Bewegung des Grundkörpers 230, 230', 330, 330' relativ zum Tragkörper 210, 210', 310, 310' entlang einer Translationsrichtung und damit eine Änderung eines ersten Istabstandes X1, bewirkt, um den ersten Istbestand X1 in Bezug auf einen vorgegebenen zweiten Sollabstand S2 einstellen zu können.

In einer bevorzugten Ausführungsform des Druckkopfes 400 sind zweite Mittel zum Beaufschlagen der Tinte im Tintenversorgungskanal 403 mit einem Unterdruck relativ zum Umgebungsluftdruck vorgesehen.

Vorzugsweise sind die zweiten Mittel zum Beaufschlagen der Tinte im Tintenversorgungskanal 403 mit einem Unterdruck relativ zum Umgebungsluftdruck als externe Mittel ausgebildet, welche mit dem Tintenversorgungskanal 403 über ein externes Tintenversorgungsrohr, das mit dem Tintenversorgungskanal verbunden ist, funktional verbunden.

Gemäß einer bevorzugten Ausführungsform des erfindungsgemässen Druckkopfes 400 ist am minimal beabstandeten Umkehrpunkt U1 der zweite Sollabstand S2 zwischen einer Stösselstirnseite 243, 343 und der Einströmöffnung 407 grösser Null. Gemäß einer weiteren bevorzugten Ausführungsform des erfindungsgemässen Druckkopfes 400 weisen das Gewinde 250a, 250a', 350a, 350a' des Elements 250, 250', 350, 350' und das Gegengewinde 250b, 250', 350b, 350b' des Grundkörpers 200, 210' oder jenes des Tragkörpers 300, 310'jeweils eine Gewindeganghöhe auf, die jeweils mindestens das 2-fache des zweiten vorgegebenen Sollabstandes S2 zwischen dem minimalen Umkehrpunkt U1 und der Einströmöffnung 407 der Düse 408 beträgt.

In einer besonders bevorzugten Ausführungsform des Druckkopfes 400 ist der Tintenkanal 403 mit Tinte befüllt, welche Tinte Partikel mit einer bestimmten Partikelgrössenverteilung aufweist, wobei der zweite vorgegebene Sollabstand S2 grösser als die D50 Partikelgrösse, vorzugsweise grösser als die D90 Partikelgrösse ist, besonders bevorzugt grösser als die maximale Partikelgrösse der Partikel ist, wobei insbesondere der zweite vorgegebene Sollabstand S2 in einem Bereich von 20 bis 150 µm, bevorzugt in einem Bereich von 50 bis 90 µm liegt.

Bevorzugt ist der zumindest einen Tintenversorgungskanal 403 mit mehrere Düsen 408 versehen und jeder Düse 408 ist ein Stössel 241, 341 einer Anordnung 200, 200', 300, 300' gemäß einem der Ansprüche 1 bis 20 zugeordnet.

Die Düsen 400 können im Tintenversorgungskanal 403 entlang einer Seitenwand 409 in vorbestimmten, vorzugsweise jeweils äquidistanten Abständen angeordnet sein.

In einer weiteren bevorzugten Ausführungsform ist keine Seitenwand des Tintenversorgungskanals 403 zusammen mit einer Düse 408 einstückig ausgeführt.

In einer weiteren bevorzugten Ausführungsform des Druckkopfes 400 ist die Düse 408 aus Keramik, Hartmetall oder oberflächenbehandeltem Stahl hergestellt und/oder die Stösselstirnseite 243, 343 zumindest abschnittsweise aus Keramik, Hartmetall oder oberflächenbehandeltem Stahl gebildet.

In einer weiteren bevorzugten Ausführungsform des Druckkopfes 400 weisen die zweiten Istabstände X2 gegenüber den vorgegebenen jeweiligen Sollabständen X2 eine Abweichung von unter ± 5% auf, vorzugweise eine Abweichung von unter ± 3% auf, besonders bevorzugt eine Abweichung von unter ± 2% auf.

In einer anderen besonders bevorzugten Ausführungsform entspricht der vorgegebene zweite Sollabstand S2 dem Abstand zwischen der Stösselstirnseite 243, 343 und der Einströmöffnung 407 am minimal beabstandeten Umkehrpunkt U1. In einer alternativen Ausführungsform entspricht der vorgegebene zweite Sollabstand S2 dem Abstand zwischen der Stösselstirnseite 243, 343 und der Einströmöffnung 407 am maximal beabstandeten Umkehrpunkt U2.

**Figur 4B** zeigt die bevorzugte erste Variante des erfindungsgemässen Druckkopfes aus **Figur 4A** im Querschnitt im nicht-angeordneten Zustand.

Erfindungsgemäss wird die Aufgabe auch durch einen Tintenstrahldrucker gelöst, der zumindest einen erfindungsgemässen Druckkopf umfasst.

Dies erfolgt erfindungsgemäss mit einem Tintenstrahldrucker, der zumindest einen Druckkopf gemäß zumindest einem der Ansprüche 21 bis 24 umfasst, wobei die zweiten Mittel zum Beaufschlagen der Tinte im zumindest einen Tintenversorgungskanal 403 des zumindest einen Druckkopfes 400 mit einem Unterdruck relativ zum Umgebungsluftdruck Teil des Tintenstrahldruckers sind, und wobei der Tintenstrahldrucker zumindest ein Tintenversorgungsrohr umfasst, der mit den zweiten Mitteln und mit dem Druckkopf funktional verbunden ist.

Erfindungsgemäss wird die Aufgabe ausserdem durch ein Verfahren zur korrigierenden Justierung eines aktuellen ersten Istabstandes X1 nach Anspruch 25 gelöst.

Dies erfolgt durch ein Verfahren zur korrigierenden Justierung eines aktuellen ersten Istabstandes X1 einer Anordnung 200, 200, 300, 300' nach zumindest einem der Ansprüche 1 bis 38, der als Abstand zwischen einer Stösselstirnseite 243, 343 und einer Unterseite 217, 317 des Tragkörpers 210, 210', 310, 310' definiert ist, in Bezug auf einen Abstand A eines Tintenversorgungskanals 403, vorzugsweise eines Druckkopfes 400 gemäß einem der Ansprüche 21 bis 24 oder eines Tintenversorgungssystems, der als Abstand zwischen einer Einsetzöffnung 405 einer Trägerseitenwand 406 des Tintenversorgungskanals 403 und der Einströmöffnung 407 einer Düse 408 des Tintenversorgungskanals 403 definiert ist, wobei das Verfahren so ausgeführt wird, dass eine Anordnung 200, 200', 300, 300' nach zumindest einem der Ansprüche 1 bis 20 bereitgestellt wird und der aktuelle erste Istabstand X1 auf einen individuell zu bestimmenden ersten Sollabstand S1 hin justiert wird, indem das Schraubgelenk der Anordnung 200, 200', 300, 300' entsprechend gedreht wird, sodass falls die Anordnung 200, 200', 300, 300' am Tintenversorgungskanal 403, vorzugsweise eines Druckkopfes 400, angeordnet wird oder ist, auch der zweite Istabstand X2 einem vorgegebenen zweiten Sollabstand S2 entspricht.

Das oben genannte Tintenversorgungssystem umfasst einen Tintenversorgungskanal 403, eine Seitenwand 409 mit zumindest einer Düse 408, einer der Seitenwand 409 gegenüberliegenden Trägerseitenwand 406 zur Ablage eines Tragkörpers 210, 210', 310, 310', welche Trägerseitenwand 406 eine Einsetzöffnung 405 zur Aufnahme eines Grundkörpers einer erfindungsgemässen Anordnung 200, 200', 300, 300' umfasst, wobei vorzugsweise die Trägerseitenwand 406 und die Seitenwand den Tintenversorgungskanal 403 bilden.

Das Tintenversorgungssystem und eine erfindungsgemässen Anordnung 200, 200', 300, 300' können miteinander einen erfindungsgemässen Druckkopf 400 bilden.

Der Abstand (A) ist dabei als Abstand zwischen der Einsetzöffnung 405 oder der Oberseite 406a der Trägerseitenwand 406 des Tintenversorgungskanals 403 und der Einströmöffnung 407 der zumindest einen Düse 408 des Tintenversorgungskanals 403 definiert.

In einer bevorzugten Ausführungsform des Verfahren wird ein erfindungsgemässer Druckkopf 400 bereitgestellt und der Tintenversorgungskanal 403 des Druckkopfes 400 wird mit Tinte gefüllt, wobei der Justierschritt durch Vergleich einer aktuellen Ist-Tropfenmasse mit einer vorgegebenen Soll-Tropfenmasse eines Tintentropfens beim Ausstoss von mehreren Tintentropfen aus einer Düse (408) mit vorgegebenen Parametern so erfolgt, dass wenn sich die Ist-Tropfenmasse von der Soll-Tropfenmasse unterscheidet, die Justierung des ersten Istabstandes (X1) durch entsprechende Betätigung des Schraubgelenks der Anordnung 200, 200', 300, 300' erfolgt bis die Ist-Tropfenmasse der Soll-Tropfenmasse im Wesentlichen entspricht und damit der erste Istabstand (X1) dem individuell zu bestimmenden ersten Sollabstand (S1) entspricht, wodurch auch der zweite Istabstand (X2) dem vorgegebenen zweiten Sollabstand (S2) entspricht.

In einer weiteren bevorzugten Ausführungsform des Verfahrens erfolgt der Abgleich der Ist-Tropfenmasse mit der Soll-Tropfenmasse mit einer Einrichtung, die eine Kamera zur Erfassung des Tropfenvolumens umfasst, die ausgelegt ist die Tropfen im Flug volumetrisch zu vermessen.

In einer anderen alternativen Ausführungsform des Verfahrens erfolgt der Abgleich der Ist-Tropfenmasse mit der Soll-Tropfenmasse durch Bedrucken eines Substrates für eine vorbestimmte Zeit mit einer bestimmten Frequenz, wobei der Vergleich gravimetrisch erfolgt.

**Figur 4C** zeigt einen Schnitt durch die Mitte einer besonders bevorzugten Ausführungsform eines Tintenversorgungssystems für den erfindungsgemässen Druckkopf 400 oder eines bevorzugten erfindungsgemässen Druckkopfes 400.

Anhand der **Figur 4C** wird ein besonders bevorzugtes Verfahren zur korrigierenden Justierung eines ersten Istabstandes X1, der als Abstand zwischen einer Stösselstirnseite 243, 342 und einer Unterseite 217, 317 eines Tragkörpers 210, 210', 310, 310' definiert wird, erläutert.

In dieser besonders bevorzugten Ausführungsform des erfindungsgemässen Verfahrens umfasst das Verfahren die folgenden Schritte:
a) Bereitstellen eines Tintenversorgungssystem umfassend einen Tintenversorgungskanal 403, eine Seitenwand 409 mit zumindest einer Düse 408, einer der Seitenwand 409 gegenüberliegenden Trägerseitenwand 406 zur Ablage eines Tragkörpers 210, 210', 310, 310', welche Trägerseitenwand 406 eine Einsetzöffnung 405 zur Aufnahme des Grundkörpers 230, 330' einer Anordnung 200, 200', 300, 300' nach zumindest einem der Ansprüche 1 bis 20 umfasst, wobei vorzugsweise die Trägerseitenwand 406 und die Seitenwand 409 den Tintenversorgungskanal 403 bilden,
b) Bereitstellen einer ersten Messvorrichtung zur Ermittlung eines Abstandes A,
c) Ermittlung des Abstandes A mittels der Messvorrichtung,
d) Bereitstellen einer Anordnung 200, 200', 300, 300' gemäß zumindest einem der Ansprüche 1 bis 20 mit Tragkörper 210, 210', 310, 310' und Aktuatorvorrichtung 230, 230',
e) Bereitstellen einer Justiervorrichtung,
f) Anordnen der Anordnung 200, 200', 300, 300' an die Justiervorrichtung an einer vorbestimmten Position,
g) Vorgeben eines zweiten Sollabstandes (S2);
h) Ermittlung des aktuellen Istabstandes (X1) mit der Justiervorrichtung;
i) Berechnung des zu bestimmenden ersten Sollabstands (S1) nach der Formel: (S1) = |(A) - (KM)| - (S2), wobei (KM) ein vorbestimmter Normalwert der Justiervorrichtung ist,
j) Justierung des ersten Istabstandes (X1) durch eine entsprechende Betätigung des Schraubgelenks, bis der erste Istabstand (X1) auf den berechneten ersten Sollabstand (S1) hin justiert ist, derart, dass der zweite Istabstand (X2) dem vorgegebenen zweiten Sollabstand (S2) entspricht, wenn die Anordnung in den Tintenversorgungskanal 403, vorzugsweise des Druckkopfes 400, eingesetzt ist.

Dabei erfolgt die Ermittlung des Abstandes A bevorzugt durch die folgenden Schritte:
a) Ermittlung des Abstandes zwischen der Messvorrichtung und der Oberseite 406a der Trägerseitenwand 406 an einem vorbestimmten ersten Messpunkt,
b) Ermittlung eines Abstandes zwischen der Messvorrichtung und der Einströmöffnung 407 der Düse 408 an einem vorbestimmten zweiten Messpunkt, und
c) anschließender Subtraktion der ermittelten Messwerte.

Bei der Messung des Abstandes zwischen der Messvorrichtung und der Einströmöffnung 407 der Düse 408 wird als Referenzpunkt für die Messung bevorzugt die in Figur 4C gezeigte Stirnseite der Düse 408, die im Tintenversorgungskanal 403 liegt, herangezogen.

Dasselbe Messprinzip gilt auch bei der Messung des Abstandes zwischen der Messvorrichtung und der Einsetzöffnung 405 der Trägerseitenwand 406. Hier wird bei der entsprechenden Messung als Referenzpunkt für die Messung bevorzugt die in Figur 4C gezeigte Oberseite 406a der Trägerseitenwand 406 herangezogen.

In einer bevorzugten Ausführungsform des alternativen Verfahrens wird als Messvorrichtung die Justiervorrichtung verwendet.

Gemäß einer besonders bevorzugten Ausführungsform des alternativen Verfahrens ist die Messvorrichtung eine Infrarotmessvorrichtung zur Abstandsmessung.

### Bezugszeichen:

- 100: Anordnung aus dem nächsten Stand der Technik
- 200, 200', 300, 300': Erfindungsgemässe Anordnung
- 210, 210', 310, 310' Tragkörper 211, 211', 311: Erstes Durchgangsloch des Tragkörpers
- 213,213: Sackloch
- 215, 315: Zweite Durchgangsbohrung
- 220, 220', 320, 320': Aktuatorvorrichtung
- 230, 230', 330, 330': Grundkörper
- 232, 332: Basiskörper
- 233,333: Bodenwand
- 233a, 333a: Durchgangsöffnung
- 233b, 333b: Hohlschaft
- 234,334: Umfangswand
- 234a, 334a: Auflage
- 234b, 334b: Erste Abdichtung
- 235, 235', 335: Deckel
- 235a`: Erstes Durchgangsloch des Deckels
- 236, 336: Verbindungsmittel
- 237, 337: Schaft
- 238: Nut
- 238a: Sperrelement
- 239, 339: Elektrodenstift
- 239a, 339a: Isolierelement
- 239b, 339b: Kabel
- 236, 336: Verbindungsmittel
- 240, 240', 340, 340': Erste Mittel zur Bewegung eines Stössels
- 241, 341: Stössel
- 242, 342: Stellelement
- 243, 343: Stösselstirnseite
- 244, 344: Langerstrecktes Verbindungselement
- 245, 345: Stösselteller
- 246, 346: Zweite Abdichtung
- 250, 250', 350, 350': Element zur Positionierung der Aktuatorvorrichtung
- 250a, 250a', 350a, 350a': Gewinde
- 250b, 250b', 350b, 350b': Gegengewinde
- 260, 360: Elastisches Element
- 270, 370,: Zweite Mittel zur Vorspannung eines Stellelements
- 271, 371: Aufsatzelement
- 273,373: Feder
- 391: Randbohrung des Deckels
- 400: Druckkopf
- 403: Tintenversorgungskanal des Druckkopfes
- 405: Einsetzöffnung der Trägerseitenwand
- 406: Trägerseitenwand
- 406a: Oberseite der Trägerseitenwand
- 407: Einströmöffnung der Düse
- 408: Düse
- 409: Seitenwand des Tintenversorgungskanals

## Patentansprüche

1. Anordnung (200, 200', 300, 300') für einen Druckkopf (400) mit einem Tragkörper (210, 210', 310, 310') zur Fixierung der Anordnung (200, 200', 300, 300') am Druckkopf (400), einer Aktuatorvorrichtung (220, 220', 330, 330') mit einem Grundkörper (230, 230', 330, 330'), der am Tragkörper (210, 210', 310, 310') angebracht ist, wobei die Aktuatorvorrichtung (220, 220', 330, 330')erste Mittel (240, 340) umfasst zur Bewegung eines Stössels (241, 341), über die der Stössel (241, 341) am Grundkörper (230, 230', 330, 330') angebracht ist und bei Ansteuerung derselben relativ dazu bewegbar ist, wobei der Grundkörper (230, 230', 330, 330') mit einem Element (250, 250', 350, 350') zur Positionierung der Aktuatorvorrichtung (220, 220', 320, 320') relativ zum Tragkörper (210, 210', 310, 310') wirkverbunden ist **dadurch gekennzeichnet, dass** die Anordnung (200, 200', 300, 300') zusätzlich umfasst:
- ein Schraubgelenk, das so ausgebildet ist, dass über dieses der Grundkörper (230, 230', 330, 330') am Tragkörper (210, 210', 310, 310') beweglich anbringbar ist, wobei das Schraubgelenk ein Gewinde (250a, 250a', 350a, 350a') und ein Gegengewinde (250b, 250b', 350b, 350b') umfasst, das in das Gewinde (250a, 250a', 350a, 350a') einschraubbar ist,
- zumindest ein elastisches Element (260, 360),
- wobei das Schraubgelenk und das zumindest eine elastische Element (260, 360) für die Positionierung der Aktuatorvorrichtung (220, 220', 320, 320') zusammenwirkend so ausgebildet sind, dass das Gewinde (250a, 250a', 350a, 350a') und das Gegengewinde (250b, 250b', 350b, 350b') mit einer Vorspannung gegeneinander verklemmt werden und dass bei Betätigung des Schraubgelenks eine Bewegung des Grundkörpers (230, 230', 330, 330') relativ zum Tragkörper (210, 210', 310, 310') entlang einer Translationsrichtung bewirkt wird,
- wobei die Anordnung (200, 200', 300, 300') zusätzlich ein Schubgelenk umfasst zum Führen des Grundkörpers (230, 230', 330, 330') relativ zum Tragkörper (210, 210', 310, 310') entlang der Translationsrichtung,
- wobei das elastische Element (260, 360) so stark ausgebildet ist, dass der Tragkörper (210, 210', 310, 310') oder der Grundkörper (230, 230', 330, 330') und das Element (250, 250', 350, 350') mit einer solch starken Vorspannung gegeneinander verklemmt werden, dass die Betätigung des Schraubgelenks nur mittels eines technischen Hilfsmittels, vorzugsweise eines geeigneten Schraubenschlüssels, durchführbar ist.

2. Anordnung (200, 200', 300, 300') nach Anspruch 1 **dadurch gekennzeichnet, dass** das Schubgelenk als Drehschubgelenk mit einem zusätzlichen rotatorischen Freiheitsgrad ausgebildet ist.

3. Anordnung (200, 200', 300, 300') nach Anspruch 1 oder 2 **dadurch gekennzeichnet, dass** das elastische Element (260, 360) am Tragkörper (210, 210', 310, 310') und am Grundkörper (230, 230', 330, 330' abstützend wirksam ist.

4. Anordnung (200, 200', 300, 300') nach zumindest einem der vorhergehenden Ansprüche **dadurch gekennzeichnet, dass** das Gewinde (250a, 250a', 350a, 350a') und das Gegengewinde (250b, 250b', 350b, 350b') jeweils als Feingewinde ausgebildet sind.

5. Anordnung (200, 200', 300, 300') nach zumindest einem der vorhergehenden Ansprüche **dadurch gekennzeichnet, dass** das elastische Element (260, 360) eine Federscheibe, vorzugsweise eine Drahtfederscheibe ist und jeweils vorzugsweise aus Metall gebildet ist.

6. Anordnung (200, 200', 300, 300') nach zumindest einem der vorhergehenden Ansprüche **dadurch gekennzeichnet, dass** der Grundkörper (230, 230', 330, 330') umfasst:
- einen Basiskörper (232, 332), mit einer Bodenwand (233, 333) die eine Durchgangsöffnung (233a, 333a) einschließt, aus welcher Bodenwand (233, 333) sich eine einen Raum zur Aufnahme eines Stellelements (242, 342) umschließende Umfangswand (234, 334) erstreckt,
- einen Deckel (235, 235', 335) zum teilweise oder vollständigen Schließen des Basiskörpers (232, 332), wobei Deckel (235, 235', 335) und Basiskörper (232, 332) über Verbindungsmittel (236, 336), die bevorzugt als Schraubverbindung ausgebildet sind, miteinander verbindbar sind,
- wobei die ersten Mittel (240, 340) ein Stellelement (242, 342) und ein längliches Verbindungselement (244, 344) umfassen,
- wobei das Verbindungselement (244, 344) am Stössel (241, 341) und am Stellelement (242, 342) angebracht ist,
- wobei das Stellelement (242, 342) im Basiskörper (232, 332) so gehaltert ist, dass das Verbindungselement (244, 344) aus dem Basiskörper (232, 332) durch die Durchgangsöffnung (233a, 333a) hinausragt und sich die Stösselstirnseite (243, 343) außerhalb des Basiskörpers (232, 332) befindet.

7. Anordnung (200, 200', 300, 300') nach Anspruch 6 **dadurch gekennzeichnet, dass** eines oder mehrere folgender Bestandteile der Anordnung (200, 200', 300, 300') ausgewählt aus der Gruppe bestehend aus: Tragkörper (210, 210', 310, 310'), Element (250, 250', 350, 350'), Bodenwand (233, 333), Umfangswand (234, 334) und Deckel (235, 235', 335) aus Metall, vorzugsweise aus Stahl, besonders bevorzugt aus Edelstahl gefertigt sind, und im Falle "mehrerer" aus demselben Metall oder Stahl oder Edelstahl gefertigt sind.

8. Anordnung (200, 200', 300, 300') nach Anspruch 6 oder 7 **dadurch gekennzeichnet ist, dass** das Stellelement (242, 342) ein Biegewandler, vorzugsweise ein plattenförmiger Biegewandler ist , der besonders bevorzugt eine zumindest einseitig mit einem piezoelektrischem Körper belegten Tragplatte umfasst, wobei der Biegewandler vorzugsweise kreisförmig ausgebildet ist.

9. Anordnung (200, 200', 300, 300') nach Anspruch 8 **dadurch gekennzeichnet, dass** das Stellelement (242, 342) so ausgebildet ist, dass der Stössels (241, 341) mit einem Richtungswechsel des Stössels (241, 341) am Umkehrpunkt (U1) mit einer Frequenz von mindestens 1,0 kHz, vorzugsweise mindestens 1,1 kHz, besonders bevorzugt von mindestens 1,2 kHz arbeiten kann.

10. Anordnung (200, 200', 300, 300') nach zumindest einem der vorhergehenden Ansprüche 6 bis 9 **dadurch gekennzeichnet, dass** der Grundkörper (230, 230', 330, 330') eine Auflage (234a, 334a) zum Tragen des Stellelements (242, 342) und zweite Mittel zur Vorspannung (270) des Stellelements (242, 342) gegen die Auflage (234a, 334a) umfasst, die das Stellelement (242, 342) mit einer vorbestimmten Kraft gegen die Auflage (234a, 334a) drückt, wenn der Deckel (235, 235', 335) in der geschlossenen Position ist.

11. Anordnung (200, 200', 300, 300') nach Anspruch 10 **dadurch gekennzeichnet, dass** die Innenseite der Umfangswand (234, 334) einen umlaufenden Flansch aufweist, der die Auflage (234a, 334a) umfasst.

12. Anordnung (200, 200', 300, 300') nach Anspruch 11 **dadurch gekennzeichnet, dass** die zweiten Mittel zur Vorspannung (270, 370) so ausgebildet sind, dass die vorbestimmte Kraft auf das Stellelement (242, 342) entlang zumindest eines Teils seines Umfangs, vorzugsweise entlang seines gesamten Umfang ausgeübt wird, wenn der Deckel (235, 235', 335) in der geschlossenen Position ist.

13. Anordnung (200, 200', 300, 300') nach zumindest einem der Ansprüche 10 bis 12 **dadurch gekennzeichnet, dass** die Mittel zur Vorspannung (270, 370) ein kappenförmiges Aufsatzelement (271, 371) umfassen, das vorzugsweise aus Polymer oder Gummi besteht, und mit einer Feder (273, 373) zusammenwirkt, die am Deckel (235, 235', 335) und am Aufsatzelement (271, 371) abstützend angeordnet ist, sodass die Feder (273, 373) und das Aufsatzelement (272, 372) miteinander eine vorbestimmte Kraft gegen das Stellelement (242, 342) ausüben, wenn der Deckel (235, 235', 335) geschlossen ist.

14. Anordnung (200, 200', 300, 300') nach zumindest einem der vorhergehenden Ansprüche 8 bis 16 **dadurch gekennzeichnet, dass** der Basiskörper (232, 332) an seiner Umfangswand (234a, 334a) eine radial umlaufende erste Abdichtung (234b, 334b) umfasst.

15. Anordnung (200, 200', 300, 300') nach zumindest einem der vorhergehenden Ansprüche 6 bis 14 **dadurch gekennzeichnet, dass** sich aus der Bodenwand (233, 333) ein Hohlschaft (233b, 333b) erstreckt, der die Durchgangsöffnung (233a, 333a) umfasst, wobei vorzugsweise das längliche Verbindungselement (244, 344) zumindest abschnittsweise in dem Hohlschaft (233b, 333b) parallel zu einer Längsmittelgeraden des Hohlschafts (233b, 333b) bewegbar geführt ist, wobei zwischen dem langerstreckten Verbindungselement (244, 344) oder dem Stösselteller (245, 345) und dem Hohlschaft (233b, 333b) eine radial umlaufende zweite Abdichtung (246, 346), insbesondere ein Dichtbalg vorgesehen ist.

16. Anordnung (200, 200') nach zumindest einem der vorhergehenden Ansprüche **dadurch gekennzeichnet, dass** das Element (250, 250') das Gewinde (250a, 250a') und der Grundkörper (230, 230') das Gegengewinde (250b, 250b') umfasst, das in das Gewinde (250a, 250a') einschraubbar ist, wobei das Schraubgelenk und das zumindest eine elastische Element (260) für die Positionierung der Aktuatorvorrichtung (220, 220') zusammenwirkend so ausgebildet sind, dass der Tragkörper (210, 210') und das Element (250, 250') mit einer Vorspannung gegeneinander verklemmt werden.

17. Anordnung (200) nach Anspruch 16 **dadurch gekennzeichnet, dass** das Gewinde (250a) des Elements (250) als Innengewinde ausgebildet ist und das Gegengewinde (250b) des Grundkörpers (230) als Aussengewinde ausgebildet ist, wobei das Element (250) vorzugsweise eine Mutter umfasst, die mit dem Gewinde (250a) versehen ist.

18. Anordnung (200) nach Anspruch 17 **dadurch gekennzeichnet, dass** ein Abschnitt des Grundkörpers (230) durch ein erstes Durchgangsloch (211) des Tragkörpers (210) hindurch gesteckt und darin gelagert ist, wobei vorzugsweise der Abschnitt des Grundkörpers (230) mit einer Wandung des ersten Durchgangslochs (211) das Schubgelenk bildet.

19. Anordnung (200) nach einem der Ansprüche 16, 17, 18 bezogen auf zumindest einem der Ansprüche 6 bis 15**dadurch gekennzeichnet, dass** der Deckel (235) einen Verschluss und einen Tragzapfen umfasst, wobei sich der Tragzapfen vom Verschluss koaxial weg erstreckt und vorzugsweise einen gegenüber dem Verschluss durchmesserkleinerem ersten Schaft (237) aufweist, der mit dem Gegengewinde (250b) versehen ist.

20. Anordnung (200) nach Anspruch 18 oder 19 **dadurch gekennzeichnet, dass** das erste Durchgangsloch (211) des Tragkörpers (210) eine erste durchgehende Bohrung ist und der Tragkörper (210) eine zweite Bohrung aufweist, die als erstes Sackloch (213) zur Aufnahme des elastischen Elements (260) ausgebildet ist, wobei das Durchgangsloch (211) ein vom ersten Sackloch (213) sich weg erstreckendes erstes Durchgangsloch (211) mit einer gegenüber dem ersten Sackloch (213) durchmesserkleineren ersten Bohrung ausgebildet ist, die vorzugsweise zur formschlüssigen Verbindung mit dem ersten Schaft (237) des Tragzapfens ausgebildet ist.

21. Druckkopf (400) für einen Tintenstrahldrucker, wobei der Druckkopf (400) zumindest einen Tintenversorgungskanal (403) und zumindest eine Düse (408) mit Düsenkanal und Einströmöffnung (407) aufweist, wobei durch die Einströmöffnung (407) Tinte aus dem Tintenversorgungskanal (403) in den Düsenkanal gepresst und aus diesem ausgestoßen werden kann, wobei die Düse (408) ortsfest an einer Seitenwand (409) des Tintenversorgungskanals (403) angeordnet ist und der zumindest einen Düse (408) ein Stössel (241) mit im Tintenversorgungskanal (403) liegender Stösselstirnseite (243), die der Einströmöffnung (407) beabstandet gegenüber liegt, zugeordnet ist, wobei der Druckkopf (400) erste Mittel umfasst zum Bewegen der Stösselstirnseite (243) in dem Tintenversorgungskanal (403) zwischen einem von der Einströmöffnung (407) der Düse (408) minimal beabstandeten Umkehrpunkt (U1) und einem von der Einströmöffnung (408) der Düse (408) maximal beabstandeten Umkehrpunkt (U2) wobei die ersten Mittel die Bewegung einer Stösselstirnseite (407) auf eine Bewegung zwischen den Umkehrpunkten (U1,U2) begrenzen wobei der Druckkopf (400) eine der Seitenwand (409) gegenüberliegende Trägerseitenwand (406) zur Ablage eines Tragkörpers (210, 210', 310, 310') umfasst, welche Trägerseitenwand (406) eine Durchgangsöffnung (405) zur Aufnahme eines Grundkörpers (230) einer Aktuatorvorrichtung (230a) umfasst, wobei der Druckkopf (400) eine erfindungsgemässe Anordnung (200, 200', 300, 300') gemäß zumindest einem der Ansprüche 1 bis 20 umfasst, die am Tintenversorgungskanal (403) angeordnet ist und mit diesem über einem Tragkörper (210, 210', 310, 310') verbunden ist, wobei die ersten Mittel (240, 340) zur Bewegung der Stösselstirnseite (243, 343) Teil der erfindungsgemässen Anordnung (200, 200', 300, 300') sind.

22. Druckkopf (400) nach Anspruch 21 **dadurch gekennzeichnet, dass** und zweite Mittel zum Beaufschlagen der Tinte im Tintenversorgungskanal (403) mit einem Unterdruck relativ zum Umgebungsluftdruck vorgesehen sind

23. Druckkopf (400) nach Anspruch 21 oder 22 **dadurch gekennzeichnet, dass** am minimal beabstandeten Umkehrpunkt (U1) der zweite Sollabstand (S2) zwischen einer Stösselstirnseite (243) und der Einströmöffnung (407) grösser Null ist.

24. Druckkopf (400) nach zumindest einem der Ansprüche 21 bis 23, **dadurch gekennzeichnet, dass** der Tintenkanal (403) mit Tinte befüllt ist, welche Tinte Partikel einer bestimmten Partikelgrössenverteilung aufweist, wobei der zweite Sollabstand (S2) grösser als die D50 Partikelgrösse mit ist, vorzugsweise grösser als die Partikelgrösse D90 ist, besonders bevorzugt grösser als die maximale Partikelgrösse ist, wobei insbesondere der zweite Sollabstand (S2) in einem Bereich von 20 bis 150µm, bevorzugt in einem Bereich von 50 und 90 µm liegt.

25. Verfahren zur korrigierenden Justierung eines aktuellen ersten Istabstandes (X1) einer Anordnung (200, 200', 300, 300') nach zumindest einem der Ansprüche 1 bis 20, der als Abstand zwischen einer Stösselstirnseite (243, 343) und einer Unterseite (217, 317) des Tragkörpers (210, 210', 310, 310') definiert ist, in Bezug auf einen Abstand (A) eines Tintenversorgungskanals (403), vorzugsweise eines Druckkopfes (400) gemäß einem der Ansprüche 21 bis 24 oder eines Tintenversorgungssystems, der als Abstand zwischen einer Einsetzöffnung (405) einer Trägerseitenwand (406) des Tintenversorgungskanals (403) und der Einströmöffnung (407) einer Düse (408) des Tintenversorgungskanals (403) definiert ist, wobei das Verfahren so ausgeführt wird, dass eine Anordnung (200, 200', 300, 300') nach zumindest einem der Ansprüche 1 bis 20 bereitgestellt wird und der aktuelle erste Istabstand (X1) auf einen individuell zu bestimmenden ersten Sollabstand (S1) hin justiert wird, indem das Schraubgelenk der Anordnung (200, 200', 300, 300') entsprechend betätigt wird, sodass falls die Anordnung (200, 200', 300, 300') an einem Tintenversorgungskanal (403), vorzugsweise des Druckkopfes (400), angeordnet wird oder ist, auch der zweite Istabstand (X2) einem vorgegebenen zweiten Sollabstand (S2) entspricht.

26. Verfahren nach Anspruch 25 **dadurch gekennzeichnet, dass** das Verfahren folgende Schritte umfasst:
a) Bereitstellen eines Tintenversorgungssystem umfassend einen Tintenversorgungskanal (403), eine Seitenwand 409 mit zumindest einer Düse 408, einer der Seitenwand 409 gegenüberliegenden Trägerseitenwand (406) zur Ablage eines Tragkörpers (210, 210', 310, 310'), welche Trägerseitenwand (406) eine Einsetzöffnung (405) zur Aufnahme des Grundkörpers (230, 330') einer Anordnung (200, 200', 300, 300') nach zumindest einem der Ansprüche 1 bis 20 umfasst, wobei vorzugsweise die Trägerseitenwand (406) und die Seitenwand (409) den Tintenversorgungskanal (403) bilden,
b) Bereitstellen einer ersten Messvorrichtung zur Ermittlung eines Abstandes A,
c) Ermittlung des Abstandes A mittels der Messvorrichtung,
d) Bereitstellen einer Anordnung (200, 200') gemäß zumindest einem der Ansprüche 1 bis 20 mit Tragkörper (210, 210') und Aktuatorvorrichtung (230, 230'),
e) Bereitstellen einer Justiervorrichtung,
f) Anordnen der Anordnung (200, 200') an die Justiervorrichtung an einer vorbestimmten Position,
g) Vorgeben eines zweiten Sollabstandes (S2);
h) Ermittlung des aktuellen Istabstandes (X1) mit der Justiervorrichtung;
i) Berechnung des zu bestimmenden ersten Sollabstands (S1) nach der Formel: (S1) = |(A) - (KM)| - (S2), wobei (KM) ein vorbestimmter Normalwert der Justiervorrichtung ist,
j) Justierung des ersten Istabstandes (X1) durch eine entsprechende Betätigung des Schraubgelenks, bis der erste Istabstand (X1) auf den berechneten ersten Sollabstand (S1) hin justiert ist, derart, dass der zweite Istabstand (X2) dem vorgegebenen zweiten Sollabstand (S2) entspricht, wenn die Anordnung in den Tintenversorgungskanal (403), vorzugsweise des Druckkopfes (400), eingesetzt ist.

## Claims

1. An assembly (200, 200', 300, 300') for a printing head (400) with a supporting body (210, 210', 310, 310') for fixing the assembly (200, 200', 300, 300') to the printing head (400), an actuator device (220, 220', 330, 330') with a main body (230, 230', 330, 330'), which is attached to the supporting body (210, 210', 310, 310'), wherein the actuator device (220, 220', 330, 330') comprises first means (240, 340) for the displacement of a tappet (241, 341) by means of which the tappet (241, 341) is attached to the main body (230, 230', 330, 330') and is displaceable in relation to the same upon actuation of said means, wherein the main body (230, 230', 330, 330') is cooperatingly connected with an element (250, 250', 350, 350') for the positioning of the actuator device (220, 220', 320, 320') in relation to the supporting body (210, 210', 310, 310'), **characterized in that** the assembly (200, 200', 300, 300') additionally comprises:
- a screw joint, which is formed such that the main body (230, 230', 330, 330') is displaceably attachable to the supporting body (210, 210', 310, 310') via said screw joint, wherein the screw joint comprises a thread (250a, 250a', 350a, 350a') and a counter thread (250b, 250b', 350b, 350b') , which is screwable into the thread (250a, 250a', 350a, 350a'),
- at least one elastic element (260, 360),
- wherein the screw joint and the at least one elastic element (260, 360) for the positioning of the actuator device (220, 220', 320, 320') is cooperatingly formed such that the thread (250a, 250a', 350a, 350a') and the counter thread (250b, 250b', 350b, 350b') are tightened to each other with a biasing and that, upon actuation of the screw joint, displacement of the main body (230, 230', 330, 330') in relation to the supporting body (210, 210', 310, 310') along a translational direction is effected, whereinthe assembly (200, 200', 300, 300') additionally comprises:
- a sliding joint for guiding the main body (230, 230', 330, 330') in relation to the supporting body (210, 210', 310, 310') along the translational direction,
- wherein the elastic element (260, 360) is made so strong that the supporting body (210, 210', 310, 310') or the main body (230, 230', 330, 330') and the element (250, 250', 350, 350') are clamped against each other with such a strong pre-load that the actuation of the screw joint can only be carried out by means of a technical aid, preferably a suitable wrench.

2. The assembly (200, 200', 300, 300') according to claim 1, **characterized in that** the sliding joint is formed as a rotary sliding joint having an additional rotational degree of freedom.

3. The assembly (200, 200', 300, 300') according to claim 1 or 2, **characterized in that** the elastic element (260, 360) is supportingly effective at the supporting body (210, 210', 310, 310') and at the main body (230, 230', 330, 330'.

4. The assembly (200, 200', 300, 300') according to at least one of the preceding claims, **characterized in that** the thread (250a, 250a', 350a, 350a') and the counter thread (250b, 250b', 350b, 350b') are each formed as a fine pitch thread.

5. The assembly (200, 200', 300, 300') according to at least one of the preceding claims, **characterized in that** the elastic element (260, 360) is a spring disc, preferably a wire spring disc, and preferably is formed of metal, respectively.

6. The assembly (200, 200', 300, 300') according to at least one of the preceding claims, **characterized in that** the main body (230, 230', 330, 330') comprises:
- a base body (232, 332), with a bottom wall (233, 333), which encloses a through opening (233a, 333a), out of which bottom wall (233, 333) a circumferential wall (234, 334) extends enclosing a space for accommodation of an adjustment element (242, 342),
- a cover (235, 235', 335) for partially or completely closing the base body (232, 332), wherein the cover (235, 235', 335) and the base body (232, 332) are connectable to each other via connecting means (236, 336), which are preferably formed as a threaded connection,
- wherein the first means (240, 340) comprise an adjustment element (242, 342) and an oblong connecting element (244, 344),
- wherein the connecting element (244, 344) is attached to the tappet (241, 341) and the adjustment element(242, 342),
- wherein the adjustment element (242, 342) is maintained in the base body (232, 332), such that the connecting element (244, 344) protrudes out of the base body (232, 332) through the through opening (233a, 333a) and the tappet front side (243, 343) is located exterior of the base body (232, 332).

7. The assembly (200, 200', 300, 300') according to claim 6, **characterized in that** one or more of the following components of the assembly (200, 200', 300, 300') selected from the group consisting of: supporting body (210, 210', 310, 310'), element (250, 250', 350, 350'), bottom wall (233, 333), circumferential wall (234, 334) and cover (235, 235', 335) is from metal, preferably steel, especially preferred stainless steel, and in the case of "more" are fabricated from the same metal or steel or stainless steel.

8. The assembly (200, 200', 300, 300') according to claim 6 or 7, **characterized in that** the adjustment element (242, 342) is a bending transducer, preferably a plate-shaped bending transducer, which especially preferred comprises a supporting plate that at least at one side, is covered with a piezoelectric body, wherein the bending transducer is preferably formed circularly.

9. The assembly (200, 200', 300, 300') according to claim 8, **characterized in that** the adjustment element (242, 342) is formed such that the tappet (241, 341) is able to operate with a change of direction of the tappet (241, 341) at the reversal point (U1) with a frequency of at least 1.0 kHz, preferably at least 1.1 kHz, especially preferred of at least 1.2 kHz.

10. The assembly (200, 200', 300, 300') according to at least one of the preceding claims 6 to 9, **characterized in that** the main body (230, 230', 330, 330') comprises a coating layer (234a, 334a) for supporting the adjustment element (242, 342), and second means for biasing (270) the adjustment element (242, 342) against the coating layer (234a, 334a), which presses the adjustment element (242, 342) against the coating layer (234a, 334a) with a predetermined force, when the cover (235, 235', 335) is in the closed position.

11. The assembly (200, 200', 300, 300') according to claim 10, **characterized in that** the inner face of the circumferential wall (234, 334) has a circumferential flange that comprises the coating layer (234a, 334a).

12. The assembly (200, 200', 300, 300') according to claim 11, **characterized in that** the second means for biasing (270, 370) are formed such that the predetermined force is applied to the adjustment element (242, 342) along at least part of its periphery, preferably along its entire periphery , when the cover (235, 235', 335) is in the closed position.

13. The assembly (200, 200', 300, 300') according to at least one of the claims 10 to 12 **characterized in that** the means for biasing (270, 370) comprise a cap-shaped cover element (271, 371), which preferably consists of polymer or rubber, and cooperates with a spring (273, 373) that is supportingly arranged at the cover (235, 235', 335) and at the cover element (271, 371), so that the spring (273, 373) and the cover element (272, 372) together exert a predetermined force against the adjustment element (242, 342) when the cover (235, 235', 335) is closed.

14. The assembly (200, 200', 300, 300') according to at least one of the preceding claims 8 to 16 **characterized in that** the base body (232, 332), on its circumferential wall (234a, 334a), comprises a radially circumferential first sealing (234b, 334b).

15. The assembly (200, 200', 300, 300') according to at least one of the preceding claims 6 to 14, **characterized in that** a hollow shaft (233b, 333b) extends out of the bottom wall (233, 333), which comprises the through opening (233a, 333a), wherein preferably the oblong connecting element (244, 344), at least sectionally in the hollow shaft (233b, 333b), is displaceably guided parallel to a longitudinal center line of the hollow shaft (233b, 333b), wherein between the longitudinally extending connecting element (244, 344) or the tappet plate (245, 345) and the hollow shaft (233b, 333b) a radially circumferential second sealing (246, 346), especially a sealing bellows is provided.

16. The assembly (200, 200') according to at least one of the preceding claims, **characterized in that** the element (250, 250') comprises the thread (250a, 250a') and the main body (230, 230') comprises the counter thread (250b, 250b'), which is screwable into the thread (250a, 250a'), wherein the screw joint and the at least one elastic element (260) for the positioning of the actuator device (220, 220') are cooperatingly formed such that the supporting body (210, 210') and the element (250, 250`) are tightened to each other with a bias.

17. The assembly (200) according to claim 16, **characterized in that** the thread (250a) of the element (250) is formed as an internal thread and the counter thread (250b) of the main body (230) is formed as an external thread, wherein the element (250) preferably comprises a nut that is provided with the thread (250a).

18. The assembly (200) according to claim 17, **characterized in that** one portion of the main body (230) is inserted through a first through-hole (211) of the supporting body (210) and is supported therein, wherein preferably the portion of the main body (230) having a walling of the first through-hole (211) forms the sliding joint.

19. The assembly (200) according to one of the claims 16, 17, 18 in relation to at least one of the claims 6 to 15, **characterized in that** the cover (235) comprises a lock and a support pin, wherein the support pin extends coaxially away from the lock and preferably has a first smaller diameter shaft (237) in relation to the lock, the shaft being provided with the counter thread (250b).

20. The assembly (200) according to claim 18 or 19, **characterized in that** the first through-hole (211) of the supporting body (210) is a first through-bore and the supporting body (210) has a second bore, which is formed as a first blind hole (213) for accommodation of the elastic element (260), wherein the through-hole (211) is formed as a through-hole (211) extending away from the first blind hole (213), the through-hole, in relation to the first blind hole (213), having a smaller diameter first bore that preferably is formed for form-fittingly connecting to the first shaft (237) of the support pin.

21. A printing head (400) for ink jet printer, wherein the printing head (400) has least one ink supply channel (403) and at least one nozzle (408) with nozzle channel and inlet opening (407), wherein ink is pressed through the inlet opening (407) from the ink supply channel (403) into the nozzle channel and may be ejected therefrom, wherein the nozzle (408) is fixedly arranged at a sidewall (409) of the ink supply channel (403) and the at least one nozzle (408) is associated to a tappet (241) with tappet front side (243) being located in the ink supply channel (403), the tappet front side being located oppositely spaced apart from the inlet opening (407), wherein the printing head (400) comprises first means for displacing the tappet front side (243) in the ink supply channel (403) between a reversal point (U1) minimally spaced apart from the inlet opening (407) of the nozzle (408) and a reversal point (U2) maximally spaced apart from the inlet opening (408) of the nozzle (408), wherein the first means limit displacement of a tappet front side (407) to displacement between the reversal points (U1,U2), wherein the printing head (400) comprises a supporting sidewall (406) opposite to the sidewall (409) for depositing a supporting body (210, 210', 310, 310'), which supporting sidewall (406) comprises a through opening (405) for accommodating a main body (230) of an actuator device (230a), **characterized in that** the printing head (400) comprises an inventive assembly (200, 200', 300, 300') according to at least one of the claims 1 to 20, which is arranged at the ink supply channel (403) and is connected therewith via a supporting body (210, 210', 310, 310'), wherein the first means (240, 340) for displacement of the tappet front side (243, 343) are part of the assembly (200, 200', 300, 300') according to the invention.

22. The printing head (400) according to claim 21, **characterized in that** and second means for pressurizing the ink in the ink supply channel (403) with subatmospheric pressure in relation to the ambient air pressure are provided.

23. The printing head (400) according to claim 21 or 22, **characterized in that** at the reversal point (U1) minimally spaced apart the second set distance (S2) between a tappet front side (243) and the inlet opening (407) is larger than zero.

24. The printing head (400) according to at least one of the claims 38 to 41, **characterized in that** the ink channel (403) is filled with ink, which ink has particles of a specified particle size distribution, wherein the second set distance (S2) is larger than the D50 particle size, preferably larger than the D90 particle size, especially preferred larger than the maximum particle size, wherein especially the second set distance (S2) is in a range from 20 to 150µm, preferably in a range from 50 and 90 µm.

25. A process for correcting adjustment of a first actual nominal distance (X1) of an assembly (200, 200', 300, 300') according to at least one of the claims 1 to 20, which is defined as a distance between a tappet front side (243, 343) and a lower side (217, 317) of the supporting body (210, 210', 310, 310') in relation to a distance (A) of an ink supply channel (403), preferably of a printing head (400) according to one of the claims 21 to 24 or of an ink supply system, which distance is defined as a distance between an insertion opening (405) of a supporting sidewall (406) of the ink supply channel (403) and the inlet opening (407) of a nozzle (408) of the ink supply channel (403), wherein the process is performed such that the assembly (200, 200', 300, 300') according to at least one of the claims 1 to 20 is provided and the actual first nominal distance (X1) is adjusted to an individual first set distance (S1) that is to be determined, by appropriately actuating the screw joint of the assembly (200, 200', 300, 300'), so that if the assembly (200, 200', 300, 300') is or will be arranged at an ink supply channel (403), preferably of the printing head (400), the second nominal distance (X2) corresponds to a specified second set distance (S2).

26. The process according to claim 25, **characterized in that** the process comprises the following steps:
a) providing an ink supply system comprising an ink supply channel (403), a sidewall 409 with at least one nozzle 408, a supporting sidewall (406) opposite to the sidewall 409 for the deposition of a supporting body (210, 210', 310, 310'), which supporting sidewall (406) comprises an insertion opening (405) for accommodation of the main body (230, 330') of an assembly (200, 200', 300, 300') according to at least one of the claims 1 to 20, wherein preferably the supporting sidewall (406) and the sidewall (409) form the ink supply channel (403),
b) providing a first measuring device for determination of a distance A,
c) determination of the distance A by means of the measuring device,
d) providing an assembly (200, 200') according to at least one of the claims 1 to 20 with supporting body (210, 210') and actuator device (230, 230'),
e) providing an adjustment device,
f) arranging the assembly (200, 200') at the adjustment device at a predetermined position,
g) specifying a second set distance (S2);
h) identifying the nominal distance (X1) with the adjustment device;
i) calulating the first set distance (S1) to be determined according to the formula: (S1) = |(A) - (KM)| - (S2), wherein (KM) is a predetermined standard value of the adjustment device,
j) adjusting the first nominal distance (X1) by appropriately actuating the screw joint, until the first nominal distance (X1) is adjusted to the calculated first set distance (S1), such that the second nominal distance (X2) corresponds to the specified second set distance (S2), when the assembly is inserted into the ink supply channel (403), preferably of the printing head (400).

## Revendications

1. Dispositif (200, 200', 300, 300') pour une tête d'impression (400) ayant un corps porteur (210, 210', 310, 310') pour fixer le dispositif (200, 200', 300, 300') sur la tête d'impression (400), un dispositif d'actionnement (220, 220', 330, 330') ayant un corps de base (230, 230', 330, 330') qui est fixé au corps porteur (210, 210', 310, 310'), le dispositif d'actionnement (220, 220', 330, 330') comprenant des premiers moyens (240, 340) pour déplacer un poussoir (241, 341), par l'intermédiaire desquels le poussoir (241, 341) est fixé sur le corps de base (230, 230', 330, 330') et peut être déplacé par rapport à ceux-ci, lorsque ceux-ci sont actionnés, le corps de base (230, 230', 330, 330') étant fonctionnellement relié à un élément (250, 250', 350, 350') pour positionner le dispositif d'actionnement (220, 220', 320, 320') par rapport au corps porteur (210, 210', 310, 310'), **caractérisé en ce que** le dispositif (200, 200', 300, 300') comprend en outre :
- un joint á vis qui est conçu de telle manière que le corps de base (230, 230', 330, 330') peut être fixé de manière mobile au corps porteur (210, 210', 310, 310') via celui-ci, le joint à vis ayant un filetage (250a, 250a', 350a, 350a') et un contre-filetage (250b, 250b', 350b, 350b') qui peut être vissé dans le filetage (250a, 250a', 350a, 350a'),
- au moins un élément élastique (260, 360),
- le joint à vis et le au moins un élément élastique (260, 360) étant conçus de manière coopérative pour le positionnement du dispositif d'actionnement (220, 220', 320, 320') de sorte que le filetage (250a, 250a', 350a, 350a') et le contre-filetage (250b, 250b', 350b, 350b') sont serrés l'un contre l'autre par une prétension et que, lorsque le joint à vis est actionné, un mouvement du corps de base (230, 230', 330, 330') par rapport au corps porteur (210, 210', 310, 310') s'effectue le long de la direction de translation,
- le dispositif (200, 200', 300, 300') comprenant en outre un joint à glissière pour guider le corps de base (230, 230', 330, 330') par rapport au corps porteur (210, 210', 310, 310 ') le long de la direction de translation,
- l'élément élastique (260, 360) étant si résistant que le corps porteur (210, 210', 310, 310') ou le corps de base (230, 230', 330, 330') et l'élément (250, 250', 350, 350') sont serrés l'un contre l'autre par une prétension si forte que l'actionnement du joint à vis ne peut être effectué qu'au moyen d'une aide technique, de préférence d'une clé de serrage appropriée.

2. Dispositif (200, 200', 300, 300') selon la revendication 1, **caractérisé en ce que** le joint à glissière est réalisé sous la forme d'un joint à glissière rotatif avec un degré de liberté rotatif supplémentaire.

3. Dispositif (200, 200', 300, 300') selon la revendication 1 ou 2, **caractérisé en ce que** l'élément élastique (260, 360) a un effet de support sur le corps porteur (210, 210', 310, 310') et sur le corps de base (230, 230', 330, 330').

4. Dispositif (200, 200', 300, 300') selon au moins l'une des revendications précédentes, **caractérisé en ce que** le filetage (250a, 250a', 350a, 350a') et le contre-filetage (250b, 250b', 350b, 350b') sont chacun conçus comme un filetage fin.

5. Dispositif (200, 200', 300, 300') selon au moins l'une des revendications précédentes, **caractérisé en ce que** l'élément élastique (260, 360) est une rondelle élastique, de préférence une rondelle élastique en fil et de préférence réalisé en métal dans chaque cas.

6. Dispositif (200, 200', 300, 300') selon au moins l'une des revendications précédentes, **caractérisé en ce que** le corps de base (230, 230', 330, 330') comprend :
- un corps de base (232, 332) avec une paroi de fond (233, 333) qui inclut une ouverture de passage (233a, 333a), une paroi périphérique (234, 334) qui entoure un espace servant à recevoir un élément de réglage (242, 342) s'étendant de ladite paroi de fond (233, 333),
- un couvercle (235, 235', 335) pour fermer partiellement ou complètement le corps de base (232, 332), le couvercle (235, 235', 335) et le corps de base (232, 332) pouvant être reliés l'un à l'autre via des moyens de connexion (236, 336) qui sont réalisés de préférence sous forme de raccord à vis,
- les premiers moyens (240, 340) comprenant un élément de réglage (242, 342) et un élément de connexion oblong (244, 344),
- l'élément de connexion (244, 344) étant fixé au poussoir (241, 341) et à l'élément de réglage (242, 342),
- l'élément de réglage (242, 342) étant maintenu dans le corps de base (232, 332) de telle manière que l'élément de connexion (244, 344) dépasse du corps de base (232, 332) à travers l'ouverture de passage (233a, 333a) et le front du poussoir (243, 343) se trouve à l'extérieur du corps de base (232, 332).

7. Dispositif (200, 200', 300, 300') selon la revendication 6, **caractérisé en ce qu'**un ou plusieurs des composants suivants du dispositif (200, 200', 300, 300') sélectionné du groupe constitué par: le corps porteur (210, 210', 310, 310'), l'élément (250, 250', 350, 350'), la paroi de fond (233, 333), la paroi périphérique (234, 334) et le couvercle (235, 235', 335) sont produits en métal, de préférence en acier, de manière particulièrement préférée en acier inoxydable, et, dans le cas de "plusieurs", ils sont produits du même métal ou acier ou acier inoxydable.

8. Dispositif (200, 200', 300, 300') selon la revendication 6 ou 7, **caractérisé en ce que** l'élément de réglage (242, 342) est un transducteur de flexion, de préférence un transducteur de flexion en forme de plaque qui comprend de manière particulièrement préférée une plaque de support couverte par un corps piézoélectrique au moins sur un côté, le transducteur de flexion ayant de préférence une forme circulaire.

9. Dispositif (200, 200', 300, 300') selon la revendication 8, **caractérisé en ce que** l'élément de réglage (242, 342) est conçu de telle manière que le poussoir (241, 341) peut travailler avec une fréquence d'au moins 1,0 kHz, de préférence d'au moins 1,1 kHz, de manière particulièrement préférée d'au moins 1,2 kHz, lorsque le poussoir (241, 341) change de direction au point d'inversion (U1).

10. Dispositif (200, 200', 300, 300') selon au moins l'une des revendications précédentes 6 à 9, **caractérisé en ce que** le corps de base (230, 230', 330, 330') comporte un support (234a, 334a) pour supporter l'élément de réglage (242, 342) et des seconds moyens pour précontraindre (270) l'élément de réglage (242, 342) contre le support (234a, 334a), l'élément de réglage (242, 342) étant pressé contre le support (234a, 334a) avec une force prédéterminée, lorsque le couvercle (235, 235', 335) est en position fermée.

11. Dispositif (200, 200', 300, 300') selon la revendication 10, **caractérisé en ce que** le côté intérieur de la paroi périphérique (234, 334) a une bride périphérique qui comprend le support (234a, 334a).

12. Dispositif (200, 200', 300, 300') selon la revendication 11, **caractérisé en ce que** les seconds moyens de prétension (270, 370) sont conçus de telle manière que la force prédéterminé soit appliquée sur l'élément de réglage (242, 342) le long d'au moins une partie de sa circonférence, de préférence le long de toute sa circonférence, lorsque le couvercle (235, 235', 335) se trouve en position fermée.

13. Dispositif (200, 200', 300, 300') selon au moins l'une des revendications 10 à 12, **caractérisé en ce que** les moyens de prétension (270, 370) comprennent un élément de chapiteau en forme de capuchon (271, 371), qui est de préférence en polymère ou en caoutchouc et coopère avec un ressort (273, 373) qui est disposé comme appui au couvercle (235, 235', 335) et à l'élément de chapiteau (271, 371), de sorte que le ressort (273, 373) et l'élément de chapiteau (272, 372) exercent ensemble une force prédéterminée contre l'élément de réglage (242, 342), lorsque le couvercle (235, 235', 335) est fermé.

14. Dispositif (200, 200', 300, 300') selon au moins l'une des revendications précédentes 8 à 16, **caractérisé en ce que** le corps de base (232, 332) comprend un premier joint radialement circonférentiel (234b, 334b) sur sa paroi périphérique (234a, 334a).

15. Dispositif (200, 200', 300, 300') selon au moins l'une des revendications précédentes 6 à 14, **caractérisé en ce qu'**une tige creuse (233b, 333b) s'étend depuis la paroi de fond (233, 333), ladite tige creuse (233b, 333b) comprenant l'ouverture de passage (233a, 333a), de préférence l'élément de connexion oblong (244, 344) étant guidé de manière mobile - au moins par passages - dans la tige creuse (233b, 333b) parallèlement à une droite médiane longitudinale de la tige creuse (233b, 333b), un second joint radialement circonférentiel (246, 346), en particulier un soufflet d'étanchéité, étant prévu entre l'élément de connexion oblong (244, 344) ou la plaque de poussoir (245, 345) et la tige creuse (233b, 333b).

16. Dispositif (200, 200') selon au moins l'une des revendications précédentes, **caractérisé en ce que** l'élément (250, 250') comporte le filetage (250a, 250a') et le corps de base (230, 230') comporte le contre-filetage (250b, 250b') qui peut être vissé dans le filetage (250a, 250a'), le joint à vis et le au moins un élément élastique (260) sont conçus à coopérer pour le positionnement du dispositif d'actionnement (220, 220') de telle sorte que le corps porteur (210, 210') et l'élément (250, 250') soient serrés l'un contre l'autre par une prétension.

17. Dispositif (200) selon la revendication 16, **caractérisé en ce que** le filetage (250a) de l'élément (250) est réalisé sous forme de filetage intérieur et le contre-filetage (250b) du corps de base (230) est réalisé sous forme de filetage extérieur, l'élément (250) comprenant de préférence un écrou muni du filetage (250a).

18. Dispositif (200) selon la revendication 17, **caractérisé en ce qu'**une section du corps de base (230) est insérée à travers un premier trou de passage (211) du corps porteur (210) et montée dans celui-ci, la section du corps de base (230) et une paroi du premier trou de passage (211) formant de préférence le joint à glissière.

19. Dispositif (200) selon l'une quelconque des revendications 16, 17, 18 se référant à au moins l'une des revendications 6 à 15, **caractérisé en ce que** le couvercle (235) comprend une fermeture et un tourillon porteur, le tourillon porteur s'étendant coaxialement depuis la fermeture, et comportant de préférence une première tige (237) qui a un diamètre plus petit que la fermeture et qui est munie du contre-filetage (250b).

20. Dispositif (200) selon la revendication 18 ou 19, **caractérisé en ce que** le premier trou de passage (211) du corps porteur (210) est un premier alésage continu et le corps porteur (210) a un deuxième alésage qui est conçu comme un premier trou borgne (213) pour recevoir l'élément élastique (260), le trou de passage (211) étant un premier trou de passage (211) s'éloignant du premier trou borgne (213) et ayant un premier alésage qui a un diamètre plus petit que le premier trou borgne (213) et qui est conçu de manière à former de préférence une connexion positive à la première tige (237) du tourillon porteur.

21. Tête d'impression (400) pour une imprimante à jet d'encre, la tête d'impression (400) ayant au moins un canal d'alimentation en encre (403) et au moins une buse (408) avec un canal de buse et une ouverture d'admission (407), l'encre pouvant être pressée du canal d'alimentation en encre (403) dans le canal de buse à travers l'ouverture d'admission et éjectée de celui-ci, la buse (408) étant agencée de manière fixe sur une paroi latérale (409) du canal d'alimentation en encre (403) et un poussoir (241) étant assigné à la au moins une buse (408), le front du poussoir (243) opposé à et espacé de l'ouverture d'admission (407) se trouvant dans le canal d'alimentation en encre (403), la tête d'impression (400) comprenant des premiers moyens pour déplacer le front du poussoir (243) dans le canal d'alimentation en encre (403) entre un point d'inversion (U1) qui à une distance minimale de l'ouverture d'admission (407) de la buse (408) et un point d'inversion (U2) qui à une distance maximale de l'ouverture d'admission (407) de la buse (408), les premiers moyens délimitant le mouvement d'un front du poussoir (407) à un mouvement entre les points d'inversion (U1, U2), la tête d'impression (400) comprenant une paroi latérale de support (406) opposée à la paroi latérale (409) pour déposer un corps porteur (210, 210', 310, 310'), laquelle paroi latérale de support (406) comprend une ouverture de passage (405) pour recevoir un corps de base (230) d'un dispositif d'actionnement (230a), la tête d'impression (400) comprenant un dispositif selon l'invention (200, 200', 300, 300') selon au moins l'une des revendications 1 à 20, qui est agencé sur le canal d'alimentation en encre (403) et relié à celui-ci par l'intermédiaire d'un corps porteur (210, 210', 310, 310'), les premiers moyens (240, 340) qui servent à déplacer le front du poussoir (243, 343) faisant partie du dispositif (200, 200', 300, 300') selon l'invention.

22. Tête d'impression (400) selon la revendication 21, **caractérisée en ce que** et des seconds moyens sont prévus, lesdits moyens servant à appliquer une pression négative par rapport à la pression atmosphérique à l'encre dans le canal d'alimentation en encre (403).

23. Tête d'impression (400) selon la revendication 21 ou 22, **caractérisée en ce que**, au point d'inversion minimalement espacé (U1), la deuxième distance de consigne (S2) entre un front du poussoir (243) et l'ouverture d'admission (407) est supérieure à zéro.

24. Tête d'impression (400) selon au moins l'une des revendications 21 à 23, **caractérisée en ce que** le canal d'encre (403) est rempli d'encre, laquelle encre a des particules d'une distribution granulométrique spécifique, la seconde distance de consigne (S2) étant supérieure à la granulométrie D50, de préférence supérieure à la granulométrie D90, de manière particulièrement préférée supérieure à la granulométrie maximale, la seconde distance de consigne (S2) étant notamment comprise dans une plage de 20 à 150 µm, de préférence dans une plage de 50 et 90 µm.

25. Procédé d'ajustage correctif d'une première distance réelle actuelle (X1) d'un dispositif (200, 200', 300, 300') selon au moins l'une des revendications 1 à 20, qui est définie comme la distance entre le front d'un poussoir (243, 343) et une face inférieure (217, 317) du corps porteur (210, 210', 310, 310') par rapport à une distance (A) d'un canal d'alimentation en encre (403), de préférence d'une tête d'impression (400) selon l'une des revendications 21 à 24 ou d'un système d'alimentation en encre, qui est défini comme une distance entre une ouverture d'insertion (405) d'une paroi latérale de support (406) du canal d'alimentation en encre (403) et l'ouverture d'admission (407) d'une buse (408) du canal d'alimentation en encre (403), le procédé étant exécuté de telle sorte qu'un dispositif (200, 200', 300, 300') est fourni selon au moins l'une des revendications 1 à 20 et la première distance réelle actuelle (X1) est ajustée à une première distance de consigne (S1) à déterminer individuellement en actionnant le joint à vis du dispositif (200, 200', 300, 300') de manière correspondante, de sorte que la seconde distance réelle (X2) correspond également à une seconde distance de consigne prédéterminée (S2), si le dispositif (200, 200', 300, 300') est agencé sur un canal d'alimentation en encre (403), de préférence de la tête d'impression (400).

26. Procédé selon la revendication 25, **caractérisé en ce que** le procédé comprend les étapes suivantes :
a) fournir un système d'alimentation en encre comprenant un canal d'alimentation en encre (403), une paroi latérale (409) avec au moins une buse (408), une paroi latérale de support (406) opposée à la paroi latérale (409) pour déposer un corps porteur (210, 210', 310, 310'), laquelle paroi latérale de support (406) comprend une ouverture d'insertion (405) pour recevoir le corps de base (230, 330') d'un dispositif (200, 200', 300, 300') selon au moins l'une des revendications 1 à 20, de préférence la paroi latérale de support (406) et la paroi latérale (409) formant le canal d'alimentation en encre (403),
b) fournir un premier dispositif de mesure pour déterminer une distance A,
c) déterminer la distance A au moyen du dispositif de mesure,
d) fournir un dispositif (200, 200') selon au moins l'une des revendications 1 à 20 avec un corps porteur (210, 210') et un dispositif d'actionnement (230, 230'),
e) fournir un dispositif d'ajustage,
f) agencer le dispositif (200, 200') sur le dispositif d'ajustage à une position prédéterminée,
g) spécifier une seconde distance de consigne (S2);
h) déterminer la distance réelle (X1) actuelle au moyen du dispositif d'ajustage;
i) calculer la première distance de consigne (S1) à déterminer selon la formule: (S1) = |(A) - (KM)| - (S2), (KM) étant une valeur standard prédéterminée du dispositif d'ajustage,
j) ajuster la première distance réelle (X1) en actionnant le joint à vis de manière appropriée jusqu'à ce que la première distance réelle (X1) soit ajustée à la première distance de consigne calculée (S1), de sorte que la seconde distance réelle (X2) correspond à la seconde distance de consigne prédéterminée (S2), lorsque le dispositif est inséré dans le canal d'alimentation en encre (403), de préférence de la tête d'impression (400).
